(19) Europäisches Patentamt
European Patent Office
Office européen des brevets

(11) **EP 1 251 361 B1**

(12) **EUROPÄISCHE PATENTSCHRIFT**

(45) Veröffentlichungstag und Bekanntmachung des Hinweises auf die Patenterteilung:
**03.02.2010  Patentblatt 2010/05**

(51) Int Cl.:
***G01R 33/34*** *(2006.01)*

(21) Anmeldenummer: **02007966.1**

(22) Anmeldetag: **10.04.2002**

(54) **Supraleitende Resonatoren für Anwendungen in der NMR**

Superconducting resonators for applications in NMR

Résonateurs supraconducteurs pour des applications dans la RMN

(84) Benannte Vertragsstaaten:
**CH FR GB LI**

(30) Priorität: **17.04.2001  DE 10118835**

(43) Veröffentlichungstag der Anmeldung:
**23.10.2002  Patentblatt 2002/43**

(73) Patentinhaber: **Bruker BioSpin AG**
**8117 Fällanden (CH)**

(72) Erfinder: **Marek, Daniel**
**5103 Möriken (CH)**

(74) Vertreter: **Kohler Schmid Möbus**
**Patentanwälte**
**Ruppmannstraße 27**
**70565 Stuttgart (DE)**

(56) Entgegenhaltungen:
**WO-A-99/24844**

**Beschreibung**

Die Erfindung betrifft einen HF(= Hochfrequenz)-Resonator gemäß dem Oberbegriff von Anspruch 1.

Eine solche Anordnung ist aus der US-A 5,585,723 bekannt.

NMR ist eine sehr aussagekräftige und genaue Methode zur Strukturanalyse chemischer Verbindungen, sie ist jedoch leider nicht sehr empfindlich. Es ist deshalb ein vordergründiges Anliegen der NMR, dass Resonatoren bereitgestellt werden, die eine möglichst hohe Empfangs-Empfindlichkeit, d.h. ein möglichst hohes S/N-Verhältnis besitzen. Dank der Verwendung von gekühlten und insbesondere supraleitenden Hochfrequenzresonatoren, ist es möglich, die Verluste im Resonator sehr klein zu halten, und damit die Empfindlichkeit wesentlich zu steigern.

Als Supraleiter eignet sich gegenwärtig HTS-Material am besten. Dieses besitzt eine hohe Sprungtemperatur und ist, verglichen mit anderen Supraleitern, sehr unempfindlich gegenüber statischen magnetischen Feldern. Erreicht werden diese guten Eigenschaften aber nur dann, wenn der Supraleiter aus sehr dünnen, epitaktischen Schichten besteht, die auf orientierten einkristallinen Substraten aufgebaut sind, wobei diese Substrate normalerweise nur als ebene Plättchen zur Verfügung stehen. Das hat zur Folge, dass die geometrische Form der Resonatoren nicht beliebig sein darf sondern aus ebenen Plättchen aufgebaut werden muss, was natürlich die möglichen geometrischen Ausführungsformen stark beschränkt.

Die zu messende Substanz ist meistens flüssig und in einem Messröhrchen eingeschlossen, das sich normalerweise auf Raumtemperatur befindet und durch ein Zwischenrohr und einer Vakuumkammer vom kalten NMR-Resonator, der sich bei ca. 20K befindet, getrennt ist.

Solche Anordnungen sind z.B. aus der US-A 5,585,723 bekannt. Die wesentlichen Probleme, die bei der Verwendung supraleitender Empfangsresonatoren auftreten, sind einerseits die vom Supraleiter erzeugte statische Magnetisierung, welche Feldinhomogenitäten erzeugen kann und das Erreichen schmaler Linien in der hochauflösenden NMR sehr stark erschwert, und anderseits der beschränkte kritische Strom im Supraleiter, der den maximalen Spulenstrom des Sendepulses begrenzt und dadurch das Erreichen kurzer Pulsbreiten für einen vorgegebenen NMR-Flipwinkel erschwert oder verhindert.

Wie bereits erwähnt spielt die Empfindlichkeit des Resonators, d.h. sein S/N-Verhältnis, eine primäre Rolle in der NMR. Sie ist abhängig vom Volumenintegral des Ausdrucks $B_1(x, y, z)/\mathrm{sqrt}\,(P)$, wobei $B_1$ das Hochfrequenzfeld am Ort x, y, z bedeutet, das durch den Resonator erzeugt wird, wenn diesem die Leistung P zugeführt wird. Wenn die Beträge der Ströme in den Leitern alle gleich gross sind, kann für die Leistung P die bekannte Gleichung $P = R \cdot I^2$ eingesetzt werden, wodurch derAusdruck im Volumenintegral zu $B_1(x, y, z)/I \cdot \mathrm{sqrt}\,(R)$ wird. Das bedeutet, dass die Empfindlichkeit umso grösser ist, je grösser das vom Resonator erzeugte Feld $B_1$ pro Einheitsstrom I und je kleiner der gesamte Verlustwiderstand R aller Leiterbahnen zusammen ist.

Der NMR-Resonator muss aber nicht nur eine hohe Empfindlichkeit besitzen, sondern auch hohe Ströme in seinen Leitern erlauben, damit während der Sendephase möglichst hohe $B_1$-Felder erzeugt werden können. Hohe $B_1$-Felder ergeben nämlich möglichst kurze Sendepulse zur Erreichung eines gewünschten NMR-Flipwinkels, und kurze Sendepulse sind in der NMR aus verschiedenen Gründen, auf die wir hier nicht eingehen wollen, sehr erwünscht. Eine hohe Empfindlichkeit des Resonators bewirkt zwar eine optimale Umsetzung des Stromes in ein $B_1$-Feld, aber das alleine genügt nicht. Auch der Strom selbst sollte möglichst hoch sein, und das hängt unter anderem vom kritischen Strom des Supraleiters und von der Breite des Leiters ab. Die Geometrie des Resonators sollte deshalb so gestaltet sein, dass diejenigen Leiter, die hauptsächlich für die Erzeugung des $B_1$-Feldes verantwortlich sind, möglichst breit sind und den vollen kritischen Strom tragen können.

Eine weitere Grösse, die das NMR-Spektrum stark beeinflusst, ist die Auflösung, die im Wesentlichen von der erzielbaren relativen Linienbreite des NMR-Signals abhängt, und diese wiederum hängt von der Homogenität des stationären Magnetfeldes $H_0$ im aktiven Bereich der Messprobe ab. Da der statische Magnetismus des supraleitenden Materials im Resonator einen starken negativen Einfluss auf die Homogenität des $H_0$-Feldes ausüben kann, und zwar bedingt durch die kurzen Distanzen zwischen Supraleiter und Messprobe, ist es notwendig, die Flächen der einzelnen supraleitenden Leitungselementen speziell zu gestalten, z.B. gemäss dem Stand der Technik durch Unterteilung aller Leiter in schmale Streifen, so dass der Einfluss des Magnetismus so weit wie möglich minimiert wird.

Die Kreisgüte Q des Resonators ist ebenfalls eine wichtige Grösse, die das NMR-Spektrum beeinflussen kann. Diese sollte nicht zu hoch sein, damit die Ein- und Ausschwingvorgänge, die hauptsächlich durch die Sendepulse verursacht werden, kurz bleiben und damit möglichst kleine unerwünschte Artefakte im NMR-Spektrum erzeugen. Da der Q-Wert gleich dem Verhältnis $\omega L/R$ ist, d.h. gleich der Impedanz der gesamten Induktivität des Resonators dividiert durch den Gesamtwiderstand aller Leiterbahnen, sollte bei gleichbleibendem Widerstand R die Induktivität L des Resonators möglichst klein sein. Das erreicht man, indem man nur jene Induktivitäten, die hauptsächlich für die Erzeugung des $B_1$-Feldes in der Messprobe verantwortlich sind, beibehält und alle anderen so weit wie möglich verkleinert oder kompensiert.

Im Weiteren sollte der Resonator die Möglichkeit erlauben, einen zweiten Resonator möglichst nahe bei der Messprobe anzubringen, und zwar so, dass dessen Magnetfeld orthogonal zu dem des ersten liegt, damit eine möglichst geringe magnetische Kopplung zwischen den beiden Resonatoren resultiert. Die Resonanzfrequenzen der beiden Resonatoren können entweder gleich oder verschieden voneinander sein, im Allgemeinen jedoch wird das letztere verwendet, wobei der zweite Resonator der Anregung oder Aufnahme einer zweiten Kernart dient. Solche orthogonale Anordnungen der Resonatoren werden in der NMR oft für spezielle Experimente benötigt.

Bekannt sind insbesondere zwei Typen von Resonatoren, nämlich der coplanare Helmholtz-Resonator (siehe US-A 5,585,723) und der Hybrid-Resonator (siehe DE 197 33 574 A1)

**Coplanarer Helmholtz-Resonator**

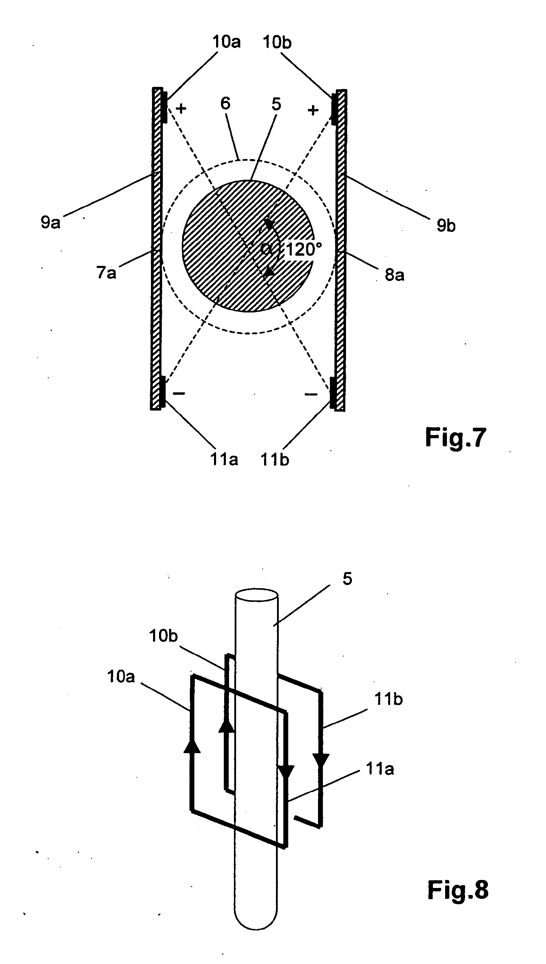

Dieser Resonator besteht aus zwei planaren Schwingkreisen in Helmholtzanordnung (siehe Fign. 7 und 8), die auf die gleiche Resonanzfrequenz $f_0$ abgestimmt sind und infolge ihrer starken induktiven Kopplung zwei Schwing-Modi erzeugen, einer unterhalb und der andere oberhalb von $f_0$. Der Modus mit der tieferen Resonanzfrequenz ist der einzige, der im Messvolumen ein homogenes $B_1$-Feld erzeugen kann. Der andere Modus erzeugt ein stark inhomogenes Feld und ist deshalb als NMR-Detektor nicht brauchbar.

Der Öffnungswinkel $\alpha$ der Resonanzkreis-Anordnung wird im Allgemeinen gleich 120° gewählt (siehe Fig. 7), um die beste Homogenität des B1-Feldes zu erreichen.

Da die Spule ausschliesslich aus supraleitendem Material besteht, sind die Verluste sehr gering, und die Empfindlichkeit könnte deshalb sehr hoch sein, wenn nicht andere Faktoren dies verhindern würden. Dazu gehört das Merkmal, dass die Leiterbahnen, bedingt durch die planare Geometrie, nicht ganz nahe an die Messprobe gesetzt werden können und deshalb ein entsprechend kleineres B1-Feld am Ort der Messprobe erzeugen. Das hat zur Folge, dass die Empfindlichkeit ebenfalls kleiner wird.

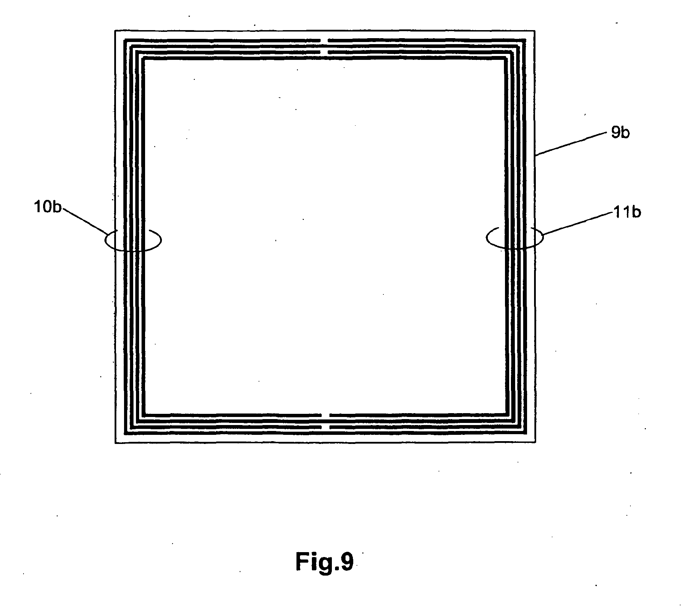

Der Aufbau jedes der beiden Schwingkreise ist in Fig. 9 dargestellt. Alle Leiter erfüllen eine Doppelfunktion, nämlich die Erzeugung der Resonanz-Induktivität wie auch der Resonanz-Kapazität des Schwingkreises, und es lässt sich zeigen, dass der grösstmögliche mittlere Strom durch diese Leiter nur gleich der Hälfte des kritischen Stromes des Supraleiters ist, sofern die einzelnen Leiter gleiche Breiten besitzen. Optimal wäre jedoch der volle kritische Strom. Das maximal erzielbare B1-Feld ist deshalb auch halb so gross, als es effektiv sein könnte.

Wird der selbe Resonator auch noch zum Senden der Anregungspulse verwendet, und das ist normalerweise der Fall, dann ist die Erzielung eines möglichst hohen Stromes in den Leitern und damit eines möglichst hohen $B_1$-Feldes von grosser Bedeutung, denn dieses bestimmt die erforderliche Pulsbreite, um einen gewünschten NMR-Flipwinkel zu erreichen, wobei die Pulsbreite möglichst klein sein sollte. Das B1-Feld wird nun einerseits durch den im vorhergehenden Absatz geschilderten Effekt halbiert und anderseits durch die relativ grosse Entfernung der Leiter von der Messprobe noch weiter reduziert.

Die durch die planare Geometrie bedingten grossen Dimensionen der beiden Schwingkreise haben schliesslich auch zur Folge, dass die Induktivität dieses Resonators um ein Vielfaches über der minimal möglichen liegt, wodurch die Güten dieser Resonatoren Werte von 30'000 und mehr erreichen. Dadurch werden hauptsächlich durch den Sendepuls Ein- und Ausschwingvorgänge ausgelöst, die zu lange andauern und dadurch Verzerrungen der Basislinie und Erzeugung von unerwünschten Artefakten im NMR-Spektrum hervorrufen.

Die grossen Dimensionen des Resonators haben zudem zur Folge, dass erstens wenig Freiraum vorhanden ist, um zusätzliche Resonatoren in der Nähe der Messprobe anzuordnen, und zweitens die Leiter des Resonators nahe an der Abschirmung liegen, mit dieser magnetisch und elektrisch koppeln, wodurch zusätzliche Verluste verursacht werden.

**Hybrid-Resonator**

Dieser Resonator wird vorzugsweise als Birdcage-Resonator ausgeführt. Er ist aus massiven, optimal um die Messprobe herum angeordneten supraleitenden Leiterbahnen aufgebaut, die parallel zur Achse der Messprobe liegen. Diese Leiterbahnen sind ihrerseits kapazitiv über je ein normalleitendes rohrförmiges Element an beiden Enden der Leiterbahnen miteinander elektrisch verbunden.

Da die Leiterbahnen sehr nahe an der Messprobe angeordnet sind, und weil diese zudem praktisch rein induktiv wirken und keine kapazitive Funktion ausüben müssen, können sie den vollen kritischen Strom tragen. Beides zusammen führt dazu, dass das im Probenvolumen maximal erzeugbare $B_1$-Feld optimal gross wird. Dieser Resonator-Typ erereicht auch dementsprechend optimal kurze Pulsbreiten für einen gewünschten NMR-Flipwinkel.

Verglichen mit dem Helmholtz-Resonator, der durchgehend reine supraleitende Schwingkreise besitzt, ist der Gesamt-Verlustwiderstand R des Hybrid-Resonators etwas höher und seine Gesamtinduktivität L infolge der kompakt um die Messprobe angeordneten Leiterbahnen viel kleiner. Das führt zu einer Kreisgüte $Q = \omega L/R$, die deutlich kleiner und damit optimaler als die des Helmholtz-Resonators ist.

Obwohl man erwarten könnte, dass der Hybrid-Resonator mit seinen höheren Gesamtverlusten ein schlechteres S/N-Verhältnis liefern würde, wird dieser Effekt durch die Leiterbahnen, die sehr viel näher bei der Messprobe angeordnet sind und deshalb ein viel grösseres B1-Feld erzeugen, wieder wett gemacht, ja sogar überkompensiert, d.h. es können sogar in gewissen Fällen höhere S/N-Verhältnisse erreicht werden als beim Helmholtz-Resonator.

Die sehr kompakte Bauweise erlaubt insbesondere bei Messproben mit grossen Durchmessern, wo der verbleibende Freiraum sehr begrenzt sein kann, optimale Einbaumöglichkeiten. Bei kleinen Durchmessern der Messprobe hingegen, führt der etwas kompliziertere Aufbau zu konstruktiven Grenzen.

Zusammenfassend sind es fünf wichtige Eigenschaften, die der NMR-Resonator besitzen sollte:

1) Er sollte eine möglichst hohe Empfindlichkeit besitzen.

2) Er sollte während der Sendephase mit möglichst kurzen Pulszeiten die gewünschten NMR-Flipwinkel erreichen.

3) Er sollte die Homogenität des stationären $H_0$-Feldes im Bereich der Messprobe möglichst wenig beeinflussen.

4) Seine Kreisgüte Q sollte nicht zu hoch sein, damit die Ein- und Ausschwingvorgänge, die hauptsächlich durch die Sendepulse verursacht werden, kurz bleiben und dadurch keine zu grossen Artefakte im NMR-Spektrum erzeugen.

5) Er sollte geometrisch so gestaltet sein, dass der benötigte Raum für den optimalen Einbau eines oder mehrerer, orthogonalen Resonatoren vorhanden ist.

Aufgabe der Erfindung ist es demgegenüber, eine neue Klasse von supraleitenden NMR-Resonatoren vorzustellen, welche die oben aufgeführten Forderungen besser erfüllen, als dies beim bekannten Stand der Technik der Fall ist.

Erfindungsgemäß wird diese Aufgabe auf ebenso überraschend einfache wie wirkungsvolle Art und Weise durch die im kennzeichnenden Teil von Anspruch 1 angegebenen Merkmale gelöst.

Aus der WO99/24844 ist ein HF-Resonator bekannt, bei dem aus supraleitfähigen Leiterstrukturen bestehende Resonanzkreise paarweise auf zueinander parallelen, einander bezüglich des Messvolumens gegenüberliegenden Substratelementen angeordnet sind, wobei die auf jeweils demselben Substratelement angeordneten Resonanzkreise ohne Überlapp nebeneinander positioniert sind. Die Resonanzkreise besitzen jeweils zwei zueinander parallele, vornehmlich induktiv wirkende Leiterstrukturen und zwei zueinander parallele, vornehmlich kapazitiv wirkende Leiterstrukturen, wobei die induktiv wirkenden Leiterstrukturen aber orthogonal zu den kapazitiv wirkenden Leiterstrukturen verlaufen.

Die Erfindung zeigt einen Weg, wie NMR-Resonatoren gebaut werden können mit verbesserter Empfindlichkeit, mit maximal kurzen Pulsbreiten zur Erreichung eines gewünschten NMR-Flipwinkels, mit möglichst kleiner Güte des Resonators und somit kleinen spektralen Artefakten, und mit einem optimalen Platzangebot für den Einbau von weiteren Resonatoren in orthogonaler Ausrichtung zum ersten Resonator. Praktisch alle diese Eigenschaften werden gegenüber dem Stand der Technik merklich verbessert.

Neben ihren hervorragenden NMR-Eigenschaften sind diese Resonatoren einfach aufgebaut und erlauben auch bei kleinen Abmessungen einen problemlosen Zusammenbau.

Weitere Vorteile ergeben sich aus den Zeichnungen und der Beschreibung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in Zeichnungen dargestellt und wird anhand von Ausführungsbeispielen näher erläutert. Es zeigen:

Fig. 1    Die bevorzugte Form des erfindungsgemässen Resonators. Er besitzt gegenüber der ersten bevorzugten Form von Fig. 3b einen Öffnungswinkel β von weniger als 60°.

Fig. 2    Zentrales Bauelement, bestehend aus einem Plättchen 1d, auf dem ein Schwingkreis 2d, 3d angebracht ist, und das in Bezug zum Messvolumen so angeordnet ist, dass das erzeugte $B_1$-Feld im Zentrum des Messvolumens ungefähr parallel zur Ebene des Plättchens liegt.

Fig. 3a    Bevorzugter erfindungsgemässer Resonator (Darstellung des B1-Feldes)

Fig. 3b    Bevorzugter erfindungsgemässer Resonator (Bezeichnung der einzelnen Teile).

Fig. 4    Stellt für sich genommen kein Ausführungsbeispiel der Erfindung dar sondern zeigt, wie der erste bevorzugte, erfindungsgemässe Resonator von Fig. 3a, 3b, 6 aus dem bekannten Helmholtz-Resonator von Fig. 7, 8 abgeleitet werden kann.

Fig. 5      Räumliche Darstellung des Resonators von Fig. 4 nach erfolgter Transformation . Der Resonator besitzt an den Stellen 7a, 7b, 8a und 8b niederohmige Verbindungen.

Fig. 6      Räumliche Darstellung des bevorzugten, erfindungsgemässen Resonators von Fig. 3a, 3b.

Fig. 7      Helmholtz-Resonator gemäss dem Stand der Technik

Fig. 8      Räumliche Darstellung des Helmholtz-Resonators von Fig. 7

Fig. 9      Eines der beiden Schwingkreise des Helmholtz-Resonators von Fig. 7. Die Resonanzkapazität ist gleichmässig über den ganzen Umfang verteilt.

Fig. 10a      Eines der vier Schwingkreise des erfindungsgemässen Resonators von Fig. 3a, 3b, 6. Die Resonanzkapazität ist von den felderzeugenden Leitern getrennt und befindet sich weit weg vom Messvolumen.

Fig. 10b      Schwingkreis wie in Fig 10a, jedoch mit verbreiterten Leitern in den Querverbindungen des Resonanzkreises.

Fig. 11      Eine weitere Variante des erfindungsgemässen Schwingkreises von Fig. 10a, bei dem alle Leiter, die vom Messvolumen genügend weit entfernt sind, in zwei Leiter abgezweigt sind, um den Verlustwiderstand zu verringern. Die Finger der Resonanzkapazität greifen paarweise ineinander.

Fig. 12      Wie Fig. 11, jedoch mit dem Unterschied, dass die Finger der Resonanzkapazität einzeln ineinander greifen.

Fig. 13      Verteilung der Stromrichtungen beim nutzbaren Schwingungs-Modus des Helmholtz-Resonators von Fig. 7, 8. Dieser er-zeugt ein homogenes $B_1$-Feld im Messvolumen.

Fig. 14      Verteilung der Stromrichtungen beim zweiten Schwingungs-Modus des Helmholtz-Resonators von Fig. 7, 8. Dieser erzeugt kein homogenes $B_1$-Feld im Messvolumen und ist als Resonator ungeeignet.

Fig. 15      Verteilung der Stromrichtungen beim bevorzugten Schwingungs-Modus des erfindungsgemässen Resonators von Fig. 3a, 3b, 6. Dieser erzeugt ein homogenes $B_1$-Feld im Messvolumen, und die Richtung des $B_1$-Feldes ist annähernd parallel zu den ebenen Plättchen, auf denen die Schwingkreise aufgebracht sind.

Fig. 16      Verteilung der Stromrichtungen beim zweiten Schwingungs-Modus des erfindungsgemässen Resonators von Fig. 3a, 3b, 6.. Dieser erzeugt kein homogenes Feld im Messvolumen und ist deshalb ungeeignet als Resonator.

Fig. 17      Verteilung der Stromrichtungen, beim dritten Schwingungs-Modus des erfindungsgemässen Resonators von Fig. 3a, 3b, 6. Dieser erzeugt im Vergleich zu Fig. 15 ein weniger homogenes und schwächeres Feld im Messvolumen, und die Richtung des aus der Überlagerung der B1-Felder der einzelnen Resonanzkreise resultierenden $B_1$-Feldes ist annähernd senkrecht zu den ebenen Plättchen, auf denen die Schwingkreise aufgebracht sind.

Fig. 18      Verteilung der Stromrichtungen beim vierten Schwingungs-Modus des erfindungsgemässen Resonators von Fig. 3a, 3b, 6.. Dieser erzeugt kein homogenes Feld im Messvolumen und ist deshalb ungeeignet als Resonator.

Fig. 19      Frequenzabstimmung des Resonators mit Hilfe einer induktiven Schleife 12und einem Trimmer 14a.

Fig. 20      Frequenzabstimmung des Resonators mit Hilfe zweier kapazitiven Plättchen 13a, 13b und zweier Trimmer 14b, 14c.

Fig. 21      Einkopplung der Sendepulse oder Auskopplung des NMR-Signals mit Hilfe einer induktiven Schleife 15 und zweier Trimmer 17a, 17b.

Fig. 22      Einkopplung der Sendepulse oder Auskopplung des NMR-Signals mit Hilfe zweier kapazitiven Plättchen 16a, 16b und dreier Trimmer 17c, 17d, 17e.

Fig. 23    Erfindungsgemässer Resonator, der aus dem bevorzugten Resonator von Fig. 3a, 3b, 6 abgeleitet wurde, nur zwei Plättchen 19a, 19b benötigt, und einen Öffnungswinkel β von 0° besitzt.

Fig. 24    Erfindungsgemässer Resonator bestehend aus nur zwei Plättchen 20b, 20d in punktsymmetrischerAnordnung.

Fig. 25    Zwei Resonatoren gemäss Fig. 24, die um 90° gegeneinander gedreht sind, d.h. orthogonal zueinander stehen.

Fig. 26    Zwei Resonatoren, einer gemäss der bevorzugten, erfindungsgemässen Anordnung von Fig. 3a, 3b, 6 mit den Plättchen 1a, 1b, 1c, 1d, und der andere nach dem Stand der Technik gemäss Fig. 7, 8 mit den Plättchen 9a, 9b. Beide Resonatoren sind orthogonal zueinander positioniert.

Fig. 27    Räumliche Darstellung der vier Plättchen 1a, 1b, 1c, 1d des Resonators von Fig. 3b.

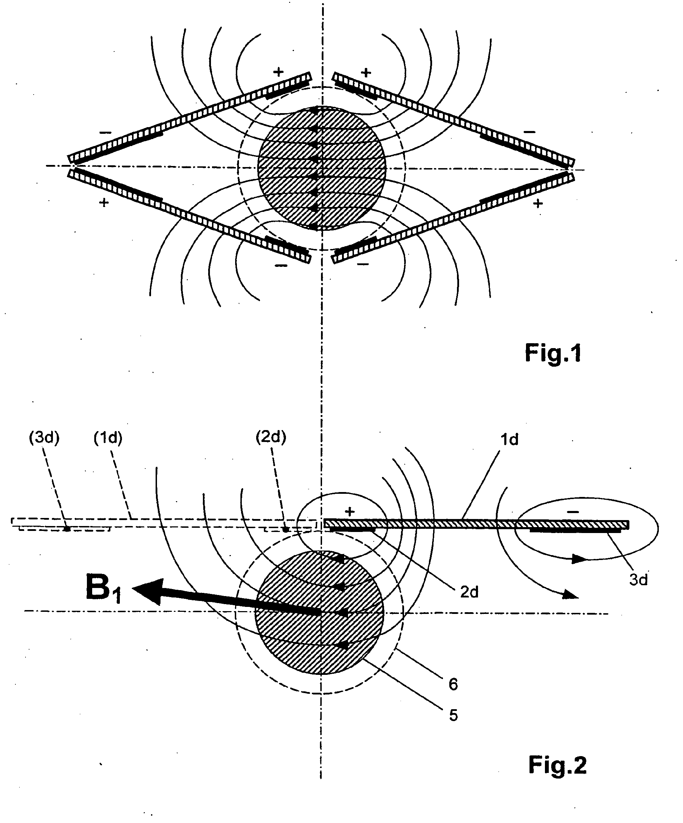

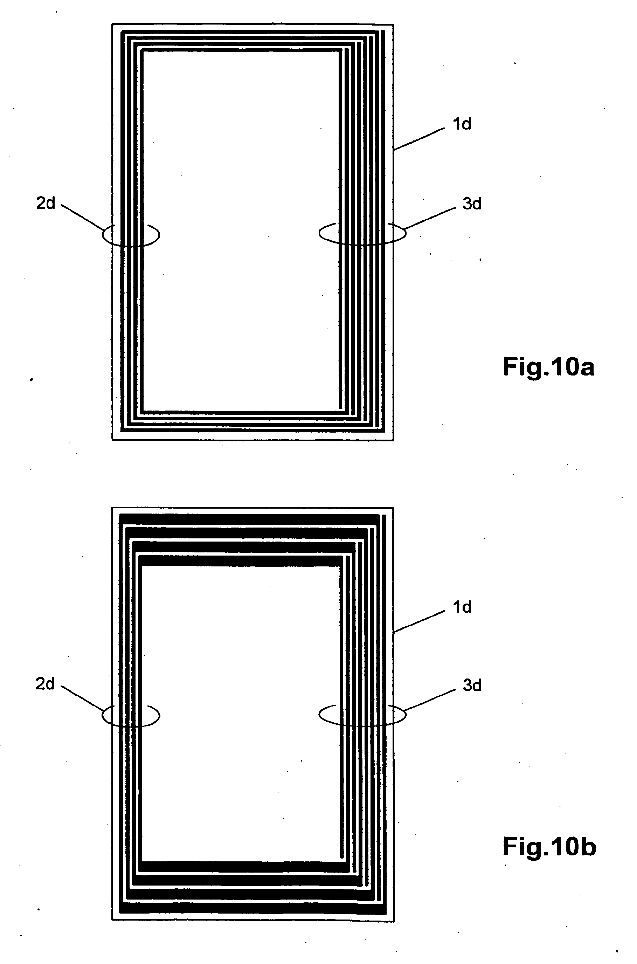

Alle erfindungsgemässen Resonatoren haben das gemeinsame Merkmal, dass sie aus mehreren gleichen elementaren Bauteilen, sogenannten Bauelementen, zusammengesetzt sind, die alle prinzipiell gemäss Fig. 2 angeordnet sind. Das Bauelement besteht aus einem Substrat-Plättchen 1d, auf dem ein supraleitender Schwingkreis 2d, 3d angebracht ist, der z.B. wie in Fig. 10a aussehen kann. Die zentralen Eigenschaften des Bauelementes sind erstens, dass es bei einem gegebenen Strom durch den Resonanzkreis ein optimal grosses $B_1$-Feld im Zentrum des Messvolumens erzeugen kann, und zweitens, dass die Richtung des B1-Feldes annähernd parallel zur Ebene des Plättchens 1d verläuft, wobei die Parallelitätsabweichung maximal 40° betragen soll. Um diese Eigenschaften zu erreichen, muss erstens ein wesentlicher Teil der Leiter auf dem Plättchen möglichst nahe beim Begrenzungszylinder 6 liegen, und zweitens das Bauelement tangential zum Begrenzungszylinder 6 angeordnet sein.

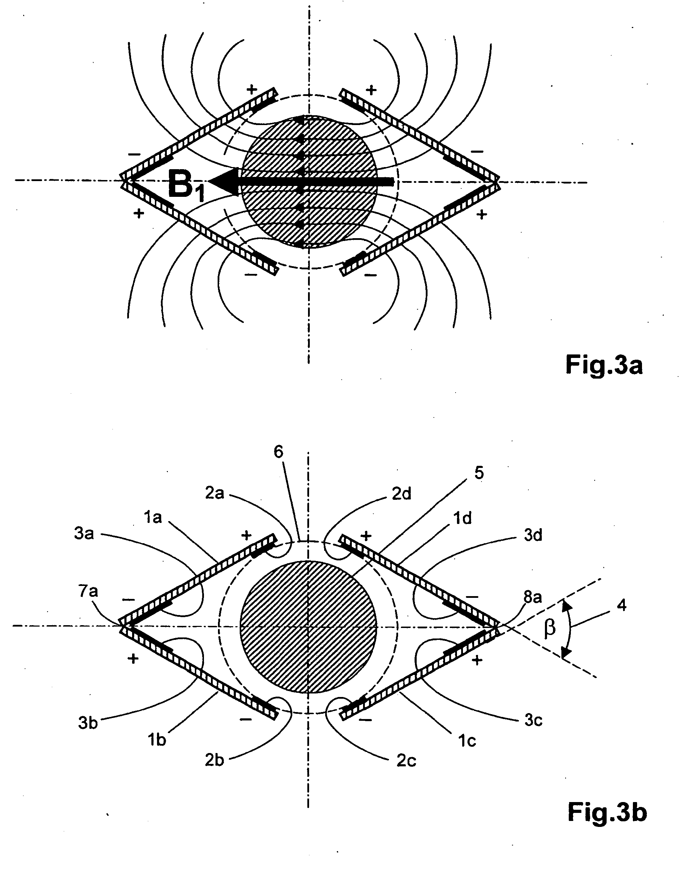

Das Plättchen 1d ist in Fig. 2 tangential nach rechts dargestellt. Es ist aber ebenso möglich, das Plättchen tangential nach links zu orientieren, wie dies gestrichelt in Fig. 2 angedeutet ist. Es lässt sich zudem an einer beliebigen Stelle auf dem Umfang des Begrenzungszylinders 6 ansetzen. Ebenso ist es möglich, das Plättchen in engeren Grenzen tangential zum Messvolumen hin, oder vom Messvolumen weg zu verschieben. Insbesondere lässt sich in Fig. 2 das Plättchen 1d so zum Messvolumen hin verschieben, dass die Leiter 2d senkrecht über dem Zentrum des Messvolumens zu liegen kommen, wie dies z.B. beim bevorzugten Resonator von Fig. 3a, 3b der Fall ist.

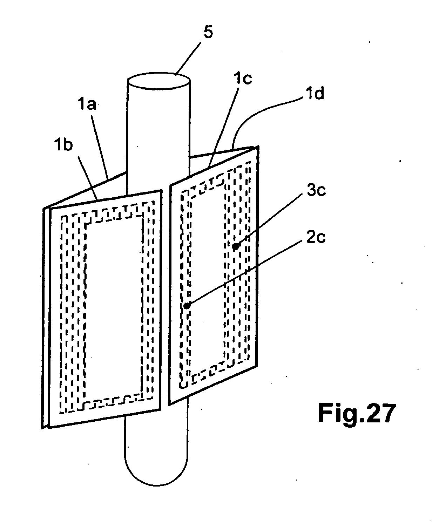

Fig. 3a, 3b zeigt einen bevorzugten erfindungsgemässen Resonator, der mit vier Bauelementen 1a, 1b, 1c, 1d gemäss Fig. 2 aufgebaut ist. Die zugehörigen Leiterbahnen sind mit 2a, 3a, 2b, 3b, 2c, 3c, 2d, 3d bezeichnet, und die vier Plättchen bilden paarweise zwei v-förmige Gebilde, die diametral und symmetrisch um die Messprobe 5 angeordnet sind (Fig. 27). Das von diesem Resonator erzeugte $B_1$-Feld ist in Fig. 3a dargestellt.

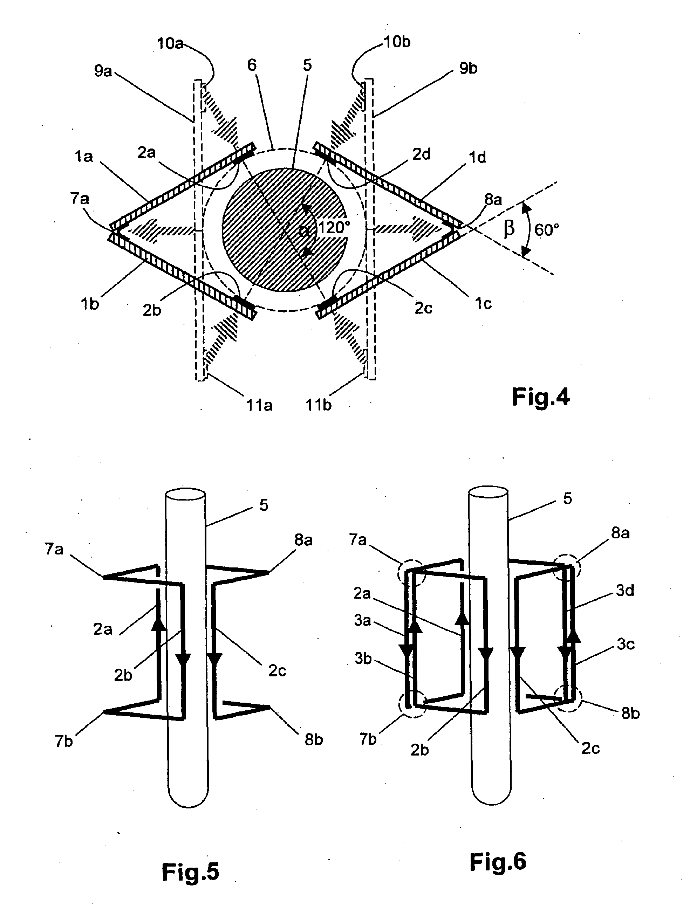

Um einen direkten und einfachen Vergleich dieses Resonators mit dem Stand der Technik nach der US-A 5,585,723 (siehe Fig. 7) zu erhalten, soll er mit Hilfe einer Transformation aus der Anordnung von Fig. 7 abgeleitet werden. Der Transformationsprozess ist in Fig. 4 dargestellt.

Ausgehend von den beiden Plättchen 9a und 9b mit den supraleitenden Leiterbahnen 10a, 11a und 10b, 11b, werden diese Plättchen in der Mitte, d.h. an den Stellen 7a und 8a parallel zur Achse der Messprobe 5 durchgeschnitten und jeweils mit einem imaginären Scharnier zusammengehalten. Durch diesen Schnitt werden auch die Verbindungsleiter, welche die Leiterbahnen 10a, 11a sowie 10b, 11b miteinander verbinden und senkrecht zurAchse der Messprobe liegen, durchgeschnitten.

Anschliessend werden die Leiterbahnen 10a, 11a und 10b, 11b zur Messprobe hin gekippt, wodurch die Schnittstellen 7a und 8a radial nach aussen wandern. Dieser Vorgang wird so lange fortgeführt, bis die Leiterbahnen den Zylinder 6, der die Begrenzung nach innen des kalten Raumes darstellt, berühren und paarweise einen Öffnungswinkel α von ca. 120° besitzen (Fig. 4). Anschliessend werden die durchgeschnitten Verbindungsleiter wieder an den Stellen 7a, 7b, 8a, 8b elektrisch miteinenader verbunden, wodurch die in Fig.5 dargestellte Anordnung resultiert.

Der Öffnungswinkel α von 120° entspricht dem Öffnungswinkel einer Helmholtzanordnung und führt zu einem möglichst homogenen $B_1$-Feld im Bereich der Messprobe.

Vergleicht man nun die ursprüngliche Anordnung von Fig. 8 mit der neuen, transformierten von Fig. 5, so lassen sich folgende Aussagen machen:

DerAbstand der Leiter 2a, 2b, 2c, 2d zur Messprobe 5 ist nach der Transformation nur noch halb so gross geworden (Fig. 4). Somit ist das $B_1$ Feld um den Faktor 2 gestiegen, wenn man annimmt, dass die Geometrie des Resonators eine viel grössere axiale als radiale Ausdehnung besitzt, und dadurch die Feldbeiträge der Verbindungsleiter quer zur Achse der Messprobe vernachlässigt werden können.

Da die gesamte Länge der Leiterbahnen unverändert geblieben ist, bleibt auch der Verlustwiderstand R des transformierten Resonators gleich, trotz der Verdoppelung des $B_1$-Feldes! Das hat zur Folge, dass der Faktor $B_1$(x, y, z)/l·sqrt (R) und somit das S/N-Verhältnis ebenfalls um den Faktor 2 gestiegen ist!

Das $B_1$-Feld ist weiterhin optimal homogen, da die Oeffnungswinkel von 120° beibehalten wurde (Fig. 4).

Die Induktivität L des Resonators ist deutlich kleiner geworden, da die effektive Spulenfläche abgenommen hat. Damit verkleinert sich die

Kreisgüte $Q = \omega L / R$ ebenfalls um den gleichen Faktor wie die Induktivität L, da R konstant geblieben ist.

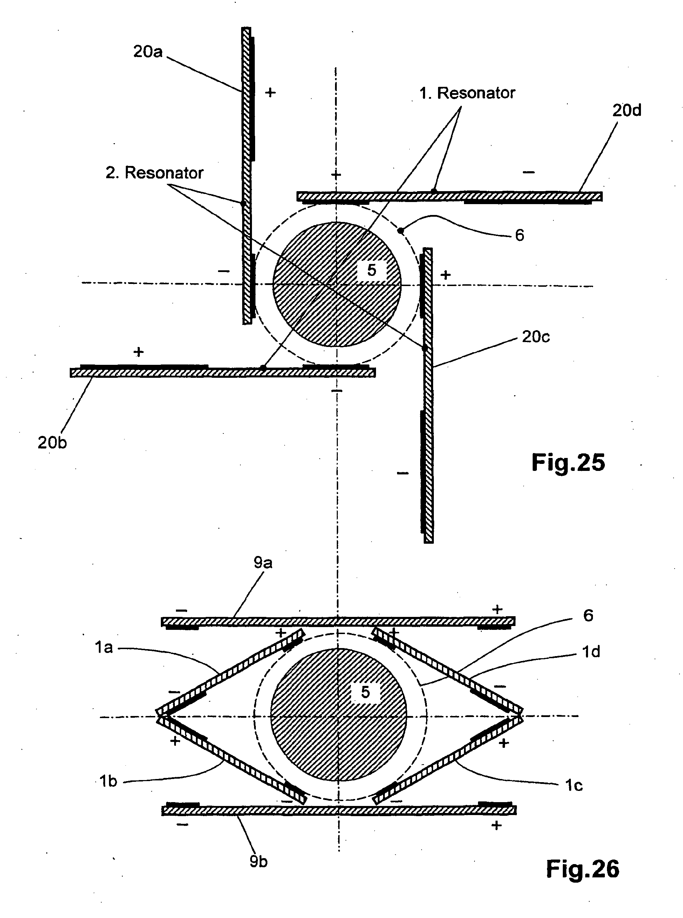

Zudem ist der Raumbedarf ebenfalls kleiner geworden, so dass eine zusätzliche, orthogonale Spule problemlos montiert und relativ nahe bei der Messprobe positioniert werden kann (Fig. 26).

Die durchgeschnittenen Querleiter, welche die Leiter 2a, 2b sowie 2c, 2d miteinander verbinden sollten, können an den vier Stellen 7a, 7b, 8a, 8b (Fig. 5) wieder elektrisch miteinander verbunden werden, und zwar entweder mit einem Supraleiter oder mit einem Normalleiter. Insbesondere die normalleitenden Verbindungen stellen eine mögliche und günstige Lösung dar, da die Verbindungen an sich sehr kurz sein können und ihre Widerstände deshalb kaum ins Gewicht fallen. Diese Variante gehört jedoch bereits zum Stand der Technik nach der DE 197 33 574 A1 und soll hier nicht als Ausführungsform der Erfindung sondern nur als Übergangsvariante zu den erfindungsgemässen Resonatoren dienen.

Solche galvanische Verbindungen sind aber nicht zwingend notwendig, um die Stromkreise auf den Plättchen 1a, 1b, 1c, 1d zu schliessen. Anstatt den Strom jeweils von einem der V-förmig angeordneten Plättchen zum andern zu leiten, wird erfindungsgemäß der Strom auf dem gleichen Plättchen und parallel zur Kante der Schnittfläche wieder zurückgeleitet. Daraus entsteht die bevorzugte erfindungsgemäße Ausführungsform von Fig. 3a,3b, 6, die gegenüber der Ausgangsform von Fig. 4, 5 einfacher und reproduzierbarer herzustellen ist. Die beiden Ströme je entlang den Kanten 7a-7b und 8a-8b sind gegensinnig, so dass das von ihnen erzeugte Magnetfeld sich gegenseitig praktisch vollständig kompensiert. Die erzeugten Felder sind deshalb praktisch identisch mit denen von Fig. 5, und die Gesamtinduktivität der beiden Anordnungen ist aus diesem Grunde auch praktisch dieselbe. Einzig der Verlustwiderstand R ist verschieden, da die Anordnung von Fig. 6 vier Längsleiter mehr besitzt als Fig. 5, nämlich 3a, 3b, 3c und 3d, und deshalb einen grösseren Verlustwiderstand besitzt.

Wenn man annimmt, dass die Resonanzkreise auf den einzelnen Plättchen zwei Mal länger als breit sind, wird der Widerstand um den Faktor 24 / 16 = 1.50 grösser, der Q-Wert um den Faktor 1 / 1.50 = 0.67 kleiner und das S/N-Verhältnis um den Faktor sqrt(0.67) = 0.82 ebenfalls kleiner. In Anbetracht des weiter oben erwähnten Gewinns an S/N-Verhältnis von einem Faktor 2, treten die soeben ermittelten Verluste von 18% nicht mehr so stark ins Gewicht. Ausserdem können die 18% durch zusätzliche Massnahmen, die weiter unten beschrieben sind, weitgehend kompensiert werden.

Die zusätzlichen Leiter 3a, 3b, 3c, 3d werden nämlich erfindungsgemäß zur Erzeugung der gesamten Kapazität des Schwingkreises benützt . Da diese Leiter relativ weit weg von der Messprobe angeordnet sind, steht einerseits mehr Platz zur Verfügung, um diese Kapazität zu realisieren, so dass eine verbesserte Spannungsfestigkeit sowie vielseitigere Gestaltungsmöglichkeiten erzielt werden können.

Anderseits können dadurch die übrigen Leiter, d.h. speziell die Leiter 2a, 2b, 2c, 2d, ausschliesslich zur Erzeugung des $B_1$-Feldes herangezogen und so dimensioniert werden, dass sie den grösstmöglichen Strom, d.h. den kritischen Strom tragen und damit das grösstmögliche $B_1$-Feld erzeugen. Es ist nämlich so, dass in den Leitern, die auch für die Erzeugung der Kapazität des Schwingkreises verantwortlich sind, der Strom vom vollen Wert linear auf Null abgebaut wird, und diese deshalb im Mittel nur den halben Strom, d.h. bestenfalls nur den halben kritischen Strom tragen. In allen anderen Leitern findet dieser Stromabbau nicht statt, so dass dort der volle kritische Strom, d.h. ein um den Faktor 2 höherer Strom fliessen kann.

Zudem kann gezeigt werden, dass der Verlustwiderstand einer Leiteranordnung mit der Gesamtbreite b, die neben ihrer induktiven Wirkung auch noch als Resonanzkapazität wirkt, um den Faktor 4/3 = 1.33 grösser ist als eine solche, die ebenfalls eine Gesamtbreite b besitzt aber nur induktiv wirkt. Das kommt ebenfalls daher, dass der Strom im Leiter mit der zusätzlichen kapazitiven Wirkung linear ab oder zunimmt, und wenn man die totale Verlustleistung bei einem gegebenen Strom durch Integration über die Länge des Leiters ermittelt, erhält man eben den bereits erwähnten effektiven Widerstand von $R \cdot (4 / 3)$.

Die mehrere Absätze weiter oben besprochene Verdoppelung des $B_1$-Feldes pro Strom im Leiterbündel, die dadurch erreicht wird, dass ein Teil der Leiter um einen Faktor 2 näher am Messvolumen liegen, zusammen mit dem zwei Absätze weiter oben besprochenen Faktor 2, ergibt gesamthaft eine Erhöhung des maximal möglichen B1-Feldes um den Faktor 4. Daraus resultiert eine vierfache Verkleinerung der erforderlichen Pulsbreite, um einen gewünschten NMR-Flipwinkel zu erreichen!

Fig. 9 zeigt einen Schwingkreis gemäss dem Stand der Technik (Fig. 8), bei dem alle Leiter sowohl induktiv wie auch kapazitiv wirken. Die Ecken der Leiteranordnung sind der Einfachheit halber rechteckig dargestellt, können aber in Wirklichkeit auch abgerundet sein, um Erhöhungen der Stromdichten in den Ecken, und damit eine Verkleinerung des kritischen Stromes in den Leitern zu vermeiden.

Fig. 10a zeigt einen erfindungsgemässen Schwingkreis, bei dem der grössere Teil der Leiter rein induktiv wirkt (2d), und bei dem die Resonanzkapazität durch die Verbindungsleiter 3d realisiert wird. Diese Verbindungsleiter sind weit weg von der Messprobe angeordnet, wirken sowohl induktiv wie auch kapazitiv und besitzen eine Gesamtbreite, die doppelt so gross ist als die der Leiter 2d. Auch hier können alle Ecken der Leiteranordnungen in Wirklichkeit abgerundet sein.

An Hand von Fig. 9 (Stand der Technik) und Fig. 10a (erfindungsgemässe Anordnung) lässt sich der Verlustwiderstand R der beiden Schwingkreise berechnen und direkt miteinander vergleichen. Es soll dabei angenommen werden, dass die Breite des Schwingkreises von Fig. 10a halb so gross und dessen Länge genau so gross wie die des Schwingkreises von Fig. 9 ist. Da der Resonator gemäss dem Stand der Technik (Fig. 9) zwei einzelne Schwingkreise besitzt, der erfindungsgemässe Resonator (Fig. 6) hingegen vier, müssen die Verluste von zwei Schwingkreisen gemäss Fig. 10a mit dem Schwingkreis von Fig. 9 verglichen werden. Für den Schwingkreis von Fig. 9 erhält man:

$$R = (s \cdot R'/n)(1.333)$$

und für den von Fig. 10a, der zwei Mal berücksichtigt werden muss:

$$R = 2 \cdot (R'/n) \cdot (s/8 + s/4 + s/8) + 2 \cdot (R'/2n) \cdot (s/4) \cdot (1.333) =$$

$$(s \cdot R'/n)(1.333)$$

wobei

s = mittlerer Umfang der Leiteranordnung von Fig. 9
R' = Widerstand pro Längeneinheit eines einzelnen Leiters
n = Anzahl Leiter in der Leiteranordnung von 10b oder 2d

Das Resultat zeigt, dass beide Anordnungen den gleichen Verlustwiderstand R besitzen.

Weiter oben wurde gezeigt, dass die vier zusätzlichen Verbindungsleiter 3a, 3b und 3c, 3d des erfindungsgemässen Resonators von Fig. 6 eine Erhöhung des Verlustwiderstandes um 18% gegenüber dem Stand der Technik (Fig. 8)verursachen, sofern die Schwingkreise gemäss dem Stand der Technik (Fig. 9) verwendet werden. Die obige Berechnung zeigt nun aber, dass diese Erhöhung des Verlustwiderstandes praktisch vollständig rückgängig gemacht werden kann mit Hilfe des neuen erfindungsgemässen Schwingkreises von Fig. 10a.

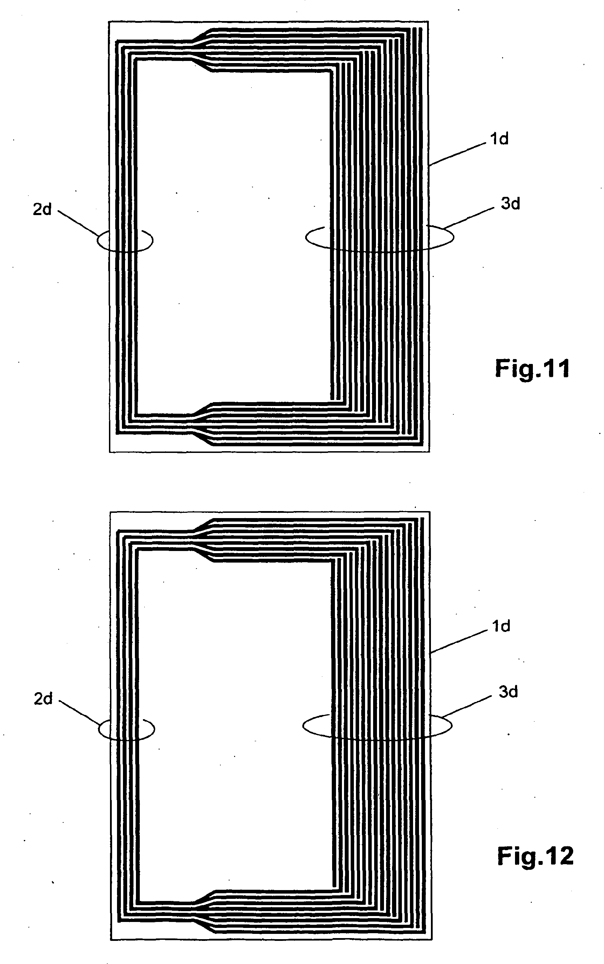

Um den Verlustwiderstand R noch weiter zu verkleinern, können die Leiteranteile, die nicht in der unmittelbaren Nähe der Messprobe sind, verbreitert (Fig. 10b) und/oder in mehrere Streifen verzweigt werden (Fig. 11 und Fig. 12). Auch hier können alle Ecken der Leiter abgerundet sein. Der Unterschied zwischen Fig. 11 und Fig. 12 liegt in derAnordnung der Leiter 3d. In Fig. 11 werden die Finger der Kapazitäten paarweise ineinander gelegt, so dass die totale Kapazität ähnlich der von Fig. 10a ist. In Fig. 12 hingegen werden die Finger einzeln ineinander gelegt, so dass praktisch eine Verdoppelung der Kapazität erreicht wird. Es ist auch möglich, einen Teil der Leiter 3d wie in Fig. 11 und die restlichen Leiter 3d wie in Fig. 12 zu gestalten, wodurch die erzielbare Kapazität des Resonators in weiten Bereichen geändert werden kann. Zudem können die Längen der einzelnen Leiter 3d, die in Fig. 10a, 10b, 11 und 12 bis zu den oberen und unteren Querleitern reichen, verkürzt werden, wodurch die gesamte Kapazität des Resonanzkreises in weiten Bereichen verkleinert werden kann.

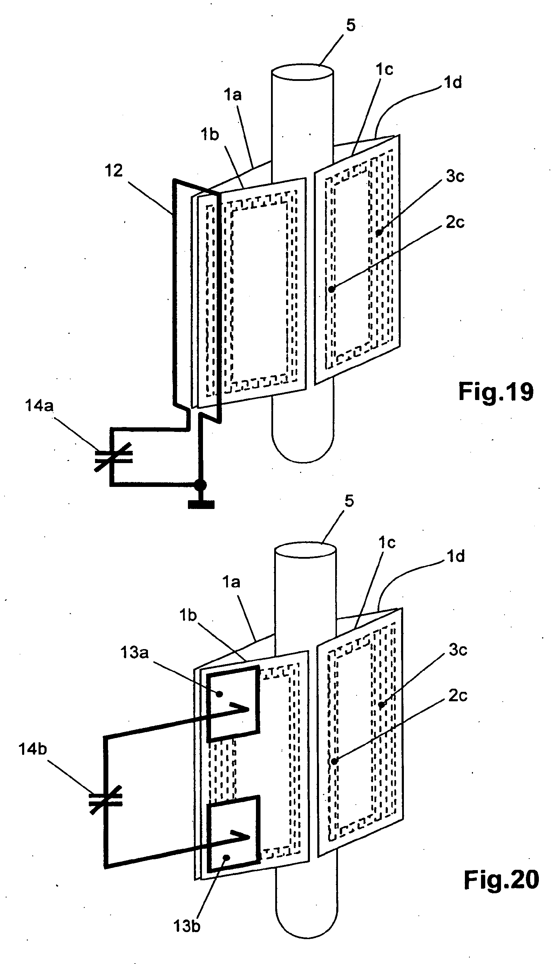

Die Frequenzabstimmung des Resonators kann entweder induktiv mit Hilfe einer Schleife 12 und dem Trimmer 14a (Fig. 19) oder aber auch kapazitiv mit Hilfe zweier Kondensator-Plättchen 13a, 13b und dem Trimmern 14 (Fig. 20) problemlos durchgeführt werden. Da die Abstimmelemente weit entfernt von der Messprobe angeordnet sind, beeinflussen sie die elektrischen und magnetischen Zustände am Ort der Messprobe nur wenig und stehen der eventuellen Montierung weiterer orthogonaler Resonatoren kaum im Wege.

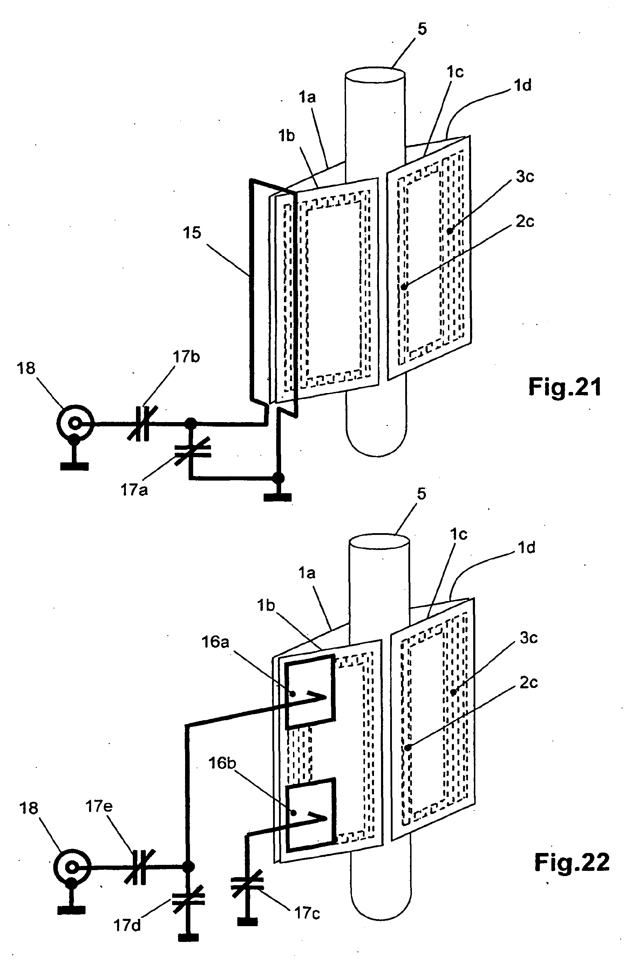

Auch die Einkopplung der Sendepulse und Auskopplung des NMR-Signals lässt sich entweder induktiv durch eine Schlaufe 15 und z.B. zweier Trimmer 17a, 17b (Fig. 21), oder aber kapazitiv durch zwei Kondensatorplättchen 16a, 16b und z.B. drei Trimmer 17c, 17d, 17e durchführen (Fig. 22). Die Kapazitäten 17a, 17b sowie 17c, 17d, 17e dienen der Impedanzanpassung zwischen dem Koaxkabel, der an der Buchse 18 angeschlossen ist, und dem Resonator. Die Frequenz des Sendepulses bestimmt den Schwingungs-Modus, der im Resonator angeregt wird. Das Koaxkabel, das an der Buchse 18 angeschlossen ist, ist für die elektrische Verbindung zwischen dem rauscharmen Vorverstäker und dem Resonator verantwortlich. Auch hier werden die Ankopplungselemente weit weg von der Messprobe im Bereich der Leiter 3a, 3b oder 3c, 3d angeordnet, um die magnetische und elektrische Beeinflussung der Messprobe möglichst klein zu halten.

Die oben beschriebenen Abstimmungs- sowie Ankopplungs-Varianten könnten durch viele andere aus der Literatur bekannten Varianten ergänzt werden.

Resonatoren, die aus mehreren Schwingkreisen zusammengesetzt sind, besitzen im Allgemeinen auch mehrere Resonanzfrequenzen, die man Schwingungs-Modi nennt. Wenn die Schwingkreise alle ungefähr die gleiche Eigen-Resonanzfrequenz $f_0$ besitzen und räumlich nahe beieinander liegen, können sie sehr stark miteinander koppeln, was zur Folge hat, dass der Resonator mehrere unterschiedliche Resonanzfrequenzen erhält. Diese sind oberhalb und unterhalb von $f_0$ verteilt, wobei die Frequenz $f_0$ selbst gar nicht mehr als Resonanzfrequenz des Resonators vorkommt. Die verschiedenen Resonanzfrequenzen unterscheiden sich dadurch, dass die Stromrichtungen in den einzelnen Schwingkreisen verschieden verteilt sind.. Bei n Schwingkreisen sind n verschiedene Verteilungen der Stromrichtungen und damit n Schwingungs-Modi möglich. Unter diesen Modi wird nur einer benutzt, nämlich der, welcher das gewünschte homogene Feld erzeugt und die besten NMR-Eigenschaften besitzt.

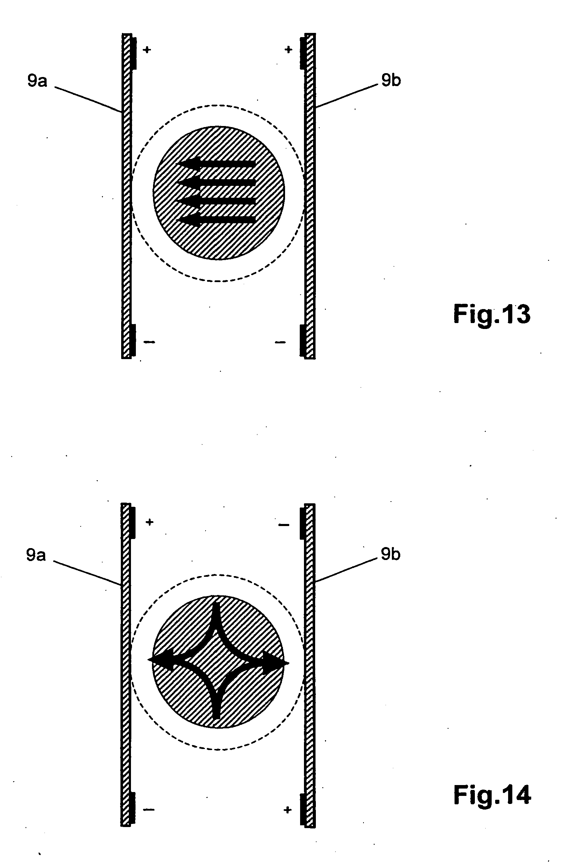

Die Helmholtzanordnung von Fig. 8 besitzt zwei mögliche Verteilungen der Stromrichtungen und damit zwei Modi, die in Fig. 13 und 14 dargestellt sind. Man beachte, dass die Beträge der Ströme aus Symmetriegründen alle gleich gross sein müssen. Der bevorzugte Modus besitzt eine Resonanzfrequenz, die unterhalb der Eigenresonanzfrequenz $f_0$ der Schwingkreise liegt und ist in Fig. 13 dargestellt. Er erzeugt im Messvolumen ein homogenes Feld, das senkrecht zu den Plättchen 9a und 9b steht. Dieser Modus wird für NMR-Resonatoren gemäss dem Stand der Technik benützt. Der zweite Modus (Fig. 14) besitzt eine höhere Resonanzfrequenz, und da er unter anderem ein stark inhomogenes Feld im Messvolumen erzeugt, ist er als NMR-Resonator ungeeignet.

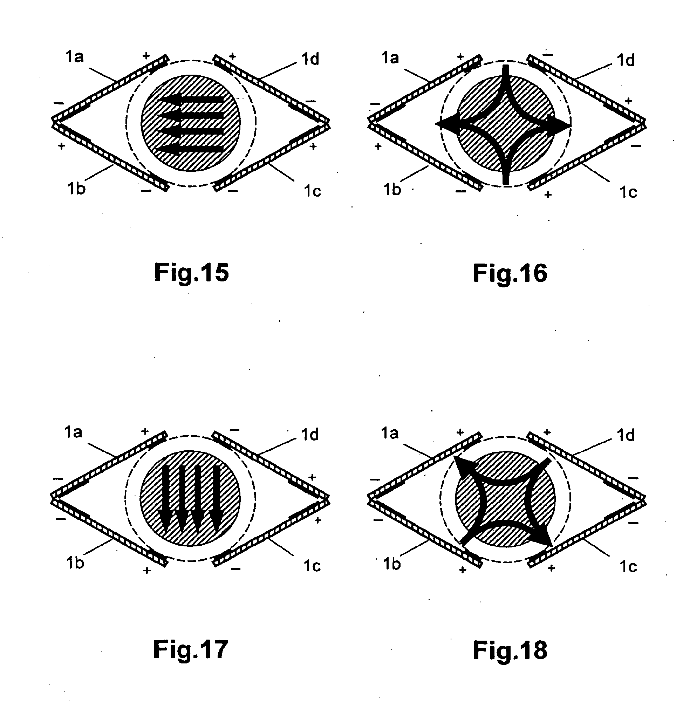

Der erfindungsgemässe und bevorzugte Resonator von Fig. 6 besitzt vier mögliche Verteilungen der Stromrichtungen in den vier Resonanzkreisen und damit vier Modi, die in Fig. 15, 16, 17, 18 dargestellt sind. Die Beträge der Ströme müssen auch hier aus Symmetriegründen alle gleich gross sein. Der bevorzugte Modus ist in Fig. 15 dargestellt. Er besitzt eine Resonanzfrequenz die oberhalb der Eigenresonanzfrequenz $f_0$ der Schwingkreise liegt und erzeugt im Messvolumen ein Feld, das annähernd parallel zu den Plättchen 1a, 1b, 1c, 1d verläuft. Fig. 17 zeigt ebenfalls einen brauchbaren aber weniger optimalen Modus mit einem Feld im Messvolumen, das annähernd senkrecht zu den Plättchen verläuft, und einer Resonanzfrequenz, die unterhalb von $f_0$ liegt. Die anderen beiden Modi von Fig. 16 und Fig. 18 sind als NMR-Resonatoren ungeeignet, da sie unter anderem ein stark inhomogenes Feld im Messvolumen erzeugen.

Für einen erfindungsgemässen Resonator gemäss Fig. 3a, 3b, 6, der einen Winkel β von 26° anstatt 60° besitzt, und bei dem die Eigen-Resonanzfrequenz $f_0$ der Schwingkreise ungefähr 360 MHz beträgt, wurden folgende Resonanzfrequenzen für die vier Modi gemessen:

| Modus | $f_1$ | $f_2$ | $f_3$ | $f_4$ |
|---|---|---|---|---|
| Zugehörige Figur | Fig. 17 | Fig. 18 | Fig. 15 | Fig. 16 |
| Resonanzfrequenz [MHz] | 298.631 | 322.434 | 415.832 | 476.988 |

Bis hier wurde nur der prinzipielle Aufbau der Resonatoren behandelt. Bei einer konkreten Ausführung werden vorteilhafterweise alle massgebenden Parameter, z.B. Leiterbreiten, Position der Leiter, Grösse der Fenster der Resonanzkreise, sowie der Oeffnungswinkel β numerisch optimiert und der besonderen Aufgabe angepasst. Genaue Berechnungen zeigen, dass die Erreichung des angestrebten Faktors 2 im S/N-Verhältnis in der Praxis von einer sorgfältigen Dimensionierung aller massgebenden Parameter abhängt.

Die konkrete und beste Konfiguration hängt vor allem vom Verhältnis Länge zu Durchmesser des Probenvolumens ab. Insbesondere ergeben genaue Rechnungen, dass es oft vorteilhaft ist, den Oeffnungswinkel β von 60° etwas zu verringern, wie dies in Fig. 1 dargestellt ist. Dadurch werden die Plättchen 1a, 1b, 1c, 1d breiter, so dass die der Probe abgewandten Leiter ebenfalls breiter und somit widerstandsarmer ausgeführt werden können. Infolge des kleineren Öffnungswinkels β kommen diese Leiter zudem winkelmässig enger zusammen, sodass sich ihre Felder wunschgemäss besser zu Null kompensieren. Die genaue Breite der felderzeugenden Leiterbahnen in der unmittelbaren Nähe der Messprobe muss ebenfalls genau bestimmt werden, um optimale Werte für die Stärke und Homogenität des $B_1$-Feldes zu erreichen. Damit kommt man zur bevorzugtesten Form des erfindungsgemässen Resonators (Fig. 1).

Ausser den beiden bevorzugten Resonatoren von Fig. 1 und Fig. 3a, 3b, 6 sind noch weitere Formen von Resonatoren möglich, welche das Bauelement von Fig. 2 benutzen.

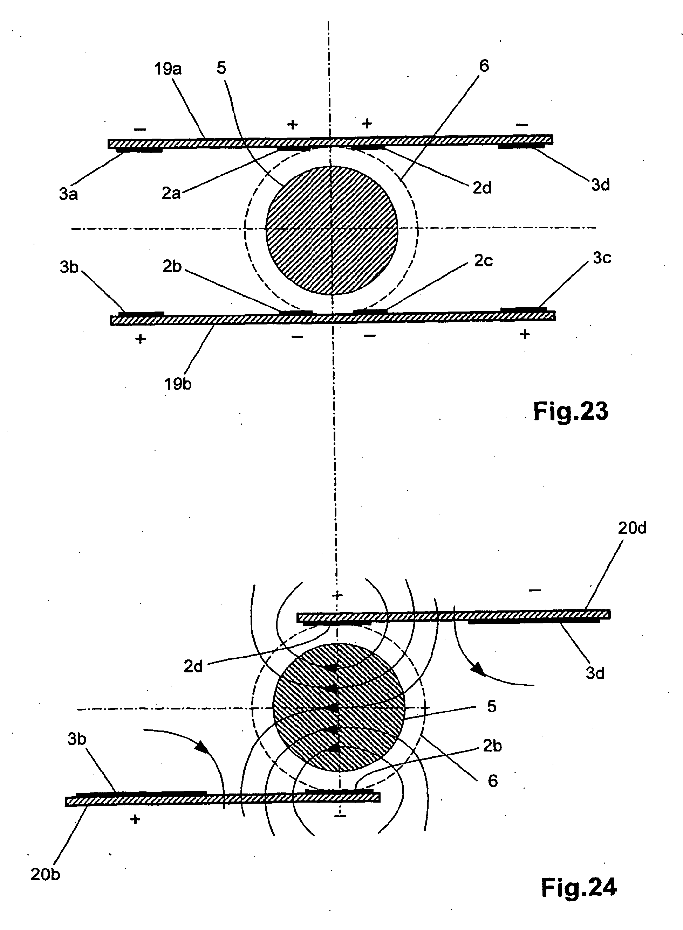

1. Der Öffnungswinkel β wird gleich 0° gesetzt und führt damit zum entarteten Fall, bei dem jeweils zwei Bauelemente zu einem einzigen zusammengesetzt werden können (Fig. 23). Das hat gewisse, jedoch recht kleine Einbussen bezüglich Feldhomogenität, S/N-Verhältnis, maximal erreichbares $B_1$-Feld und minimale Induktivität zur Folge. Trotzdem bleibt diese Anordnung dem Helmholtzspulenpaar von Fig. 7, 8 überlegen. Der Vorteil dieser Anordnung liegt in ihrer Einfachheit wie auch im verfügbaren Raum zwischen den beiden ebenen Plättchen. Zudem bietet auch diese Anordnung genügend freien Raum, um weitere Resonatoren aussen herum hinzuzufügen.

2. Von den vier Bauelementen in Fig. 3b und Fig. 23 können jeweils zwei entfernt werden, wodurch eine punktsymmetrische Anordnung gemäss Fig. 24 entsteht. Das hat einen Verlust im S/N-Verhältnis von etwas weniger als Wurzel 1/2, aber praktisch keine Verringerung des maximal möglichen $B_1$-Feldes zur Folge. Benutzt wird derjenige Schwingungs-Modus, bei dem die Ströme in den beiden am nächsten bei der Messprobe liegenden Leitern jeweils entgegengesetzt gerichtet sind. Aus Symmetriegründen sind die Beträge der Ströme auch hier gleich gross.

Alle diese erfindungsgemässen Resonatoren stellen genügend Freiraum zur Verfügung, damit weitere Resonatoren hinzugefügt werden können, die nahe an der Messprobe und orthogonal zum ersten Resonator angeordnet werden können. Auf diese Weise entstehen die folgenden Doppel-Resonator-Anordnungen:

1.Aussen am Resonator von Fig. 3a, 3b, 6 wird ein zweiter gemäss Fig. 7, 8 angeordnet. Daraus entsteht die in Fig. 26 dargestellte Anordnung zweier Resonatoren. Die beiden Felder $B_1$ und $B_2$, die vom ersten resp. zweiten Resonator im Zentrum des Messvolumens erzeugt werden, stehen senkrecht aufeinander. Man beachte, dass auch der zweite Resonator 9a, 9b (Fig. 26) sehr nahe beim Begrenzungszylinder 6 liegt und damit praktisch optimal angeordnet ist!

2.Auch beim Resonator von Fig. 23 kann, analog zum obigen Punkt 1, ein zweiter Resonator 9a, 9b sehr nahe beim Begrenzungszylinder 6 angebracht werden. In diesem Fall ist es sogar möglich, den zweiten Resonator ebenfalls auf den beiden Plättchen 19a, 19b (Fig. 23), entweder aussen oder innen am Plättchen anzubringen. Auch hier liegen die beiden Felder $B_1$ und $B_2$, die vom ersten resp. zweiten Resonator im Zentrum des Messvolumens erzeugt werden, senkrecht aufeinander.

3.Zum Resonator von Fig. 24 kann ein weiterer, identischer Resonator hinzugefügt werden, der gegenüber dem ersten um 90° gedreht ist, so dass keine Kopplung zwischen den beide Resonatoren vorhanden ist. Auch hier liegen die beiden Felder $B_1$ und $B_2$, die vom ersten resp. zweiten Resonator im Zentrum des Messvolumens erzeugt werden, senkrecht aufeinander.
Diese Anordnung ist in Fig. 25 dargestellt. Sie eignet sich insbesondere wenn zwei verschiedene Kernarten (z.B. 1H und 13C, oder 1H und 19F), die verschiedene NMR-Frequenzen besitzen, mit möglichst hoher Empfindlichkeit untersucht werden sollen, wobei beide Kernarten die selbe Priorität bezüglich hoher Empfindlichkeit haben sollen.

Der zweite Resonator, der aussen am ersten angebracht ist, braucht nicht unbedingt aus Material aufgebaut zu sein, das supraleitend ist, sondern kann auch normalleitend sein. Es ist auch möglich, mehrere Resonatoren aussen am ersten Resonator anzubringen.

Anordnungen mit mehreren Resonatoren können auch zur Erzeugung von räumlichen Drehfeldern benutzt werden. So lassen sich z.B. die beiden Resonatoren von Fig. 25 auf die gleiche Frequenz abstimmen und in Quadratur betreiben, d.h. der zweite Resonator wird mit Sendepulsen angeregt, deren Hochfrequenzphase um 90° gegenüber den Sendepulsen des ersten Resonators verschoben sind. Man kann zeigen, dass dadurch ein räumliches Drehfeld entsteht, das sich viel effizienter zur Anregung des Spinsystems eignet als das normale, räumlich stationäre Feld. Zudem gewinnt man durch das Quadratur-Verfahren einen Faktor Wurzel 2 an S/N-Verhältnis gegenüber dem gewöhnlichen Verfahren mit nur einem Resonator, weil das Rauschen der beiden Resonatoren nicht miteinander korreliert ist. Auch das maximale B1-Anregungsfeld erhöht sich um den Faktor Wurzel 2. Dieses Verfahren ist besonders geeignet, um verlustbehaftete Messproben, z.B. Salzlösungen, mit einem hohem S/N-Verhältnis zu messen.

Die Effizienz der Drehfelderzeugung kann gegenüber dem Doppelresonator von Fig. 25 noch gesteigert werden, indem n Bauelementen benützt werden, die gemäss Fig. 2 aufgebaut und symmetrisch um das Messvolumen herum angeordnet sind. Das Plättchen 1d des verwendeten Bauelementes ist so angeordnet, dass der Leiter 2d senkrecht über dem Zentrum des Messvolumens liegt. Angefangen mit einem ersten Bauelement, werden n-1 weitere indentische Bauelemente hinzugefügt, wobei diese gegenüber dem ersten um 360°/n, 2·360°/n, 3·360°/n, ....., (n-1)·360°/n um die Längsachse des Messvolumens gedreht werden. Dabei entsteht ein rosettenartiges, symmetrisches Gebilde, mit dem ein Drehfeld angeregt werden kann. Die Anregung des Drehfeldes lässt sich z.B. mit zwei induktiven Schleifen (Fig. 21) erreichen, die räumlich um 90° zueinander gedreht sind und durch HF-Impulse angeregt werden, die ebenfalls um 90° zueinander phasenverschoben sind. Die beiden induktiven Schleifen erzeugen dadurch ein Drehfeld, mit dem sich das Drehfeld des rosettenartigen Resonators leicht anregen lässt.

Der Wert von n darf infolge räumlichen Anforderungen nicht zu hoch gewählt werden. Ein Wert von n=8 bis 10 dürfte in der hochauflösenden NMR die obere Grenze darstellen. Wählt man n=8, dann sind gegenüber der Anordnung von Fig. 25, bei der n=4 gilt, die doppelte Anzahl Leiter an der Erzeugung des Drehfeldes beteiligt, wodurch das maximal erreichbare Drehfeld, verglichen mit n=4, annähernd verdoppelt und auch die Empfindlichkeit weiter gesteigert wird.

Bezugszeichenliste

| | |
|---|---|
| 1a, 1b, 1c, 1d | Einkristalline Substrate in Form ebener Plättchen, die zum bevorzugten, erfindungsgemässen Resonator gehören (Fig. 3a, 3b, 6). Diese dienen zur Aufnahme der epitaktischen Leiterschichten aus HTS-Material. |
| 2a, 2b, 2c, 2d | HTS-Leiter, die zum erfindungsgemässen Schwingkreis gemäss Fig.10, 11 oder 12 gehören. Diese Leiter liegen parallel zur Messprobe und dienen hauptsächlich der Erzeugung des $B_1$-Feldes. |
| 3a, 3b, 3c, 3d | HTS-Leiter, die zum erfindungsgemässen Schwingkreis gemäss Fig.10, 11 oder 12 gehören. Diese Leiter liegen parallel zur Messprobe und dienen der Erzeugung der Resonanzkapazität. |
| 4 | Öffnungswinkel β der beiden v-förmig angeordneten Plättchen des bevorzugten Resonators von Fig. 3a, 3b, 6. |
| 5 | Messprobe |
| 6 | Begrenzungszylinder, welche die Trennung zwischen dem kalten Raum des Resonators und dem warmen Raum der Messprobe angibt. |
| 7a, 7b | Niederohmige Verbindungsleiter zwischen dem Plättchen 1a und 1b. |
| 8a, 8b | Niederohmige Verbindungsleiter zwischen dem Plättchen 1c und 1d. |
| 9a, 9b | Einkristalline Substrate in Form ebener Plättchen, die zum Helmholtz-Resonator gemäss dem Stand der Technik gehören (Fig. 7, 8). Diese dienen zur Aufnahme der epitaktischen Leiterschichten aus HTS-Material. |
| 10a, 10b | Supraleitende Leiter auf dem Plättchen 9a resp. 9b, die zum Schwingkreis gemäss Fig. 9 gehören und parallel zur Messprobe liegen. |
| 11a, 11b | Supraleitende Leiter auf dem Plättchen 9a resp. 9b, die zum Schwingkreis gemäss Fig. 9 gehören und parallel zur Messprobe liegen. |
| 12 | Koppelschleife für die induktive Frequenzabstimmung des Resonators |
| 13a, 13b | Kondensatorplättchen für die kapazitive Frequenzabstimmung des Resonators. |
| 14a, 14b | Trimmer zur genauen Frequenzabstimmung des Resonators |
| 15 | Koppelschleife für die induktive Ein- und Auskopplung der Sende pulse resp. des NMR-Signals. |
| 16a, 16b | Kondensatorplättchen für die Kapazitive Ein- und Aus-kopplung der Sendepulse resp. Des NMR-Signals. |
| 17a, 17b | Trimmer für die Impedanzanpassung zwischen Koaxkabel und Resonator, wenn letzterer induktiv angekoppelt wird. |
| 17c, 17d, 17e | Trimmer für die Impedanzanpassung zwischen Koaxkabel und Resonator, wenn letzterer kapazitiv angekoppelt wird. |
| 18 | Anschlussbuchse des Koaxkabels, das die Sendepulse zuführt oder das NMR-Signal wegführt. |
| 19a, 19b | Einkristalline Substrate in Form ebener Plättchen, die zum Resonator in Fig. 23 gehören. |
| 20b, 20d | Einkristalline Substrate in Form ebener Plättchen, die zum Resonator in Fig. 24 oder zum ersten der |

beiden Resonatoren in Fig. 25 gehören.

20a, 20c       Einkristalline Substrate in Form ebener Plättchen, die zum zweiten der beiden Resonatoren in Fig. 25 gehören.
                    Beide Resonatoren sind orthogonal zueinander angeordnet.

**Patentansprüche**

1. HF(= Hochfrequenz)-Resonator für den Empfang von NMR-Messsignalen aus einer Messprobe (5) in einem NMR-Spektrometer, wobei sich die Messprobe im Betrieb im Messvolumen des Resonators befindet, wobei das Messvolumen in einer räumlichen Dimension länger ausgedehnt ist als in den beiden anderen und eine Längsachse aufweist, welche durch das Zentrum des Messvolumens verläuft, wobei der Resonator mehrere untereinander gleiche Bauelemente umfasst, die jeweils einen oder mehrere aus supraleitfähigen Leiterstrukturen (2a-d,3a-d) bestehende Resonanzkreise auf einem planaren Substratelement (1a-d,19a,b,20a-d)aufweisen, und wobei die Bauelemente um das Messvolumen herum angeordnet sind und die Ebenen der Substratelemente tangential zu einem gedachten, die Längsachse des Messvolumens umgebenden Begrenzungszylinder (6) verlaufen, innerhalb dessen das Messvolumen liegt,
   **dadurch gekennzeichnet,**

   - **dass** jeder einzelne zum HF-Resonator gehörende Resonanzkreis auf den planaren Substratelementen für sich genommen, wenn er stromdurchflossen ist, ein HF-Magnetfeld (= B1-Feld) im Zentrum des Messvolumens erzeugt, das parallel zur Ebene des planaren Substratelementes verläuft, auf dem sich der Resonanzkreis befindet, wobei die Abweichung von der Parallelität maximal 40 Grad betragen soll,
   - **dass** die Resonanzkreise auf den planaren Substratelementen jeweils eine parallel zur Längsachse des Messvolumens verlaufende, supraleitfähige Leiterstruktur (2a-d) zur Erzeugung des B1-Feldes und eine ebenfalls parallel zur Längsachse des Messvolumens verlaufende, supraleitfähige, kapazitiv wirkende Leiterstruktur (3a-d) zur Erzeugung der Resonanzkapazität aufweisen, wobei die Leiterstruktur zur Erzeugung des B1-Feldes diejenigen Bereiche des Resonanzkreises umfasst, die den maximalen Strom im Resonanzkreis tragen und die kapazitiv wirkende Leiterstruktur diejenigen Bereiche des Resonanzkreises umfasst, in denen der Strom auf Null abgebaut wird,
   - **dass** die Leiterstruktur zur Erzeugung des B1-Feldes von der kapazitiv wirkenden Leiterstruktur getrennt angeordnet ist und mit ihr über quer zur Längsachse des Messvolumens verlaufende Leiter verbunden ist,
   - und **dass** die Leiterstruktur (2a-d) zur Erzeugung des B1-Feldes näher am Messvolumen angeordnet ist als die kapazitiv wirkende Leiterstruktur (3a-d).

2. HF- Resonator nach Anspruch 1, **dadurch gekennzeichnet, dass** alle supraleitfähigen Resonanzkreise auf den planaren Substratelementen (1a, 1 b, 1c, 1d, 19a, 19b, 20a, 20b, 20c, 20d) auf dieselbe Resonanzfrequenz abgestimmt sind.

3. HF- Resonator nach einem der vorhergehenden Ansprüche, **dadurch gekennzeichnet, dass** zumindest ein Teil der Leiterstruktur (2a, 2b, 2c, 2d) zur Erzeugung des B1-Feldes den Begrenzungszylinder (6) berührt.

4. HF- Resonator nach einem der vorhergehenden Ansprüche, **dadurch gekennzeichnet, dass** die supraleitfähigen Leiterbahnen der zur Erzeugung der Resonanzkapazität dienenden Leiterstruktur (3a, 3b, 3c, 3d) jeweils durch Verzweigung einer Leiterbahn in zwei oder mehrere Leiterbahnen gebildet werden.

5. HF- Resonator nach Anspruch 4, **dadurch gekennzeichnet, dass** in der zur Erzeugung der Resonanzkapazität dienenden Leiterstruktur der Resonanzkreise verzweigte Leiterbahnen fingerförmig ineinander greifen, wobei jeder Finger von einem Paar von Leiterbahnen gebildet wird.

6. HF-Resonator nach Anspruch 4, **dadurch gekennzeichnet, dass** in der zur Erzeugung der Resonanzkapazität dienenden Leiterstruktur der Resonanzkreise die verzweigten Leiterbahnen einzeln fingerförmig ineinander greifen.

7. HF- Resonator nach Anspruch 4, **dadurch gekennzeichnet, dass** in der zur Erzeugung der Resonanzkapazität dienenden Leiterstruktur der Resonanzkreise ein Teil der verzweigten Leiterbahnen paarweise fingerförmig und der übrige Teil einzeln fingerförmig ineinander greifen.

**8.** HF- Resonator nach einem der vorhergehenden Ansprüche, **dadurch gekennzeichnet, dass** die supraleitfähigen Leiterstrukturen auf der dem Messvolumen zugewandten Seite der planaren Substratelemente (1a, 1b, 1c, 1d, 19a, 19b, 20a, 20b, 20c, 20d) angeordnet sind.

**9.** HF- Resonator nach einem der vorhergehenden Ansprüche, **dadurch gekennzeichnet, dass** zwei identische planare Substratelemente (20b, 20d) vorgesehen sind, wobei das zweite Substratelement (20d) gegenüber dem ersten Substratelement (20b) um 180 Grad um die Längsachse des Messvolumens gedreht ist.

**10.** HF- Resonator einem der vorhergehenden Ansprüche, **dadurch gekennzeichnet, dass** n identische planare Substratelemente (20a, 20b, 20c, 20d)) vorgesehen sind, die gegenüber einem ersten Substratelement um 360/n, 2·360/n, 3·360/n ....., (n-1)·360/n Grad um die Längsachse des Messvolumens gedreht sind und dadurch ein symmetrisches Gebilde erzeugen.

**11.** HF- Resonator nach Anspruch 10, in soweit Anspruch 10 sich nicht auf Anspruch 9 bezieht, **dadurch gekennzeichnet, dass** n=4.

**12.** HF- Resonator nach einem der Ansprüche 1 bis 8, **dadurch gekennzeichnet, dass** zwei parallel zueinander und beiderseits des Messvolumens liegende planare Substratelemente (19a, 19b) so angeordnet sind, dass sie zueinander symmetrisch bezüglich einer Ebene sind, welche die Längsachse des Messvolumens enthält und parallel zur Substratelementebene ist, und dass auf jedem der beiden Substratelemente (19a, 19b) jeweils zwei supraleitfähige Resonanzkreise vorgesehen sind, die bezüglich einer Ebene, welche die Längsachse des Messvolumens enthält und senkrecht zur Substratelementebene ist, zueinander symmetrisch sind.

**13.** HF-Resonator nach einem der Ansprüche 1 bis 8, **dadurch gekennzeichnet, dass** zwei Paare von jeweils V-förmig zueinander angeordneten, planaren Substratelementen (1a-d) mit der offenen Seite der jeweiligen V-Form dem Messvolumen zugewandt sind, wobei die Paare bezüglich einer die Längsachse des Messvolumens enthaltenden Ebene zueinander symmetrisch positioniert sind, und dass auf den einzelnen Substratelementen (1 a-d) jeweils ein supraleitfähiger Resonanzkreis vorgesehen ist, von dem zumindest ein Teil der zur Erzeugung des B1-Feldes dienenden Leiterstruktur den Begrenzungszylinder (6) berührt.

**14.** HF- Resonator nach einem der vorhergehenden Ansprüche, **dadurch gekennzeichnet, dass** die quer zur Längsachse des Meßvolumens verlaufenden Leiter verbreiterte Leiterbahnen aufweisen.

**15.** HF-Resonatoranordnung mit einem HF-Resonator nach einem der vorhergehenden Ansprüche, **dadurch gekennzeichnet, dass** zusätzlich mindestens ein weiterer supraleitfähiger oder normalleitender HF-Resonator vorgesehen ist.

**16.** HF-Resonatoranordnung nach Anspruch 15, **dadurch gekennzeichnet, dass** mindestens einer der weiteren HF-Resonatoren ebenfalls einen HF-Resonator gemäß einem der Ansprüche 1 bis 14 bildet.

**17.** HF-Resonatoranordnung mit einem HF-Resonator nach Anspruch 13, **dadurch gekennzeichnet, dass** um die Paare von jeweils V-förmig zueinander angeordneten planaren Substratelementen (1a, 1b, 1c, 1d) herum auf der dem Messvolumen abgewandten Seite der Substratelemente des HF-Resonators ein HF-Helmholtz-Resonator so angeordnet ist, dass der HF-Helmholtz-Resonator, wenn er stromdurchflossen ist, im Zentrum des Messvolumens ein B1-Feld erzeugt, das senkrecht zu dem B1-Feld des HF-Resonators nach Anspruch 13 steht, welches sich durch Überlagerung der B1-Felder der einzelnen Resonanzkreise ergibt, wenn diese gleichzeitig von Strom durchflossen sind.

**Claims**

**1.** HF(= high-frequency) resonator for the reception of NMR measurement signals from a measuring sample (5) in a NMR spectrometer, the measuring sample being enclosed in the measuring volume of the resonator during operation; the measuring volume having a longer extension in one spatial dimension than in the two other dimensions and having a longitudinal axis which extends through the center of the measuring volume; the resonator comprising multiple identical structural elements, said structural elements each having one or more resonant circuits on a planar substrate element (1a-d, 19a, b, 20a-d) consisting of superconducting conducting structures (2a-d, 3a-d); and the structural elements being disposed about the measuring volume and the planes of the substrate elements extending tangentially to an imaginary limiting cylinder (6) surrounding the longitudinal axis of the measuring volume, within which the measuring volume is located,
**characterized in**

- **that** each individual current-carrying resonant circuit belonging to the HF-resonator on the planar substrate elements per se generates a HF magnetic field (= field B1) in the center of the measuring volume which extends parallel to the plane of the planar substrate element on which the resonant circuit is located, wherein the design parallelity deviation does not exceed 40 degrees at most,
- **that** the resonant circuits on the planar substrate elements each have a superconducting conducting structure (2a-d) for generating a field B1 extending parallel to the longitudinal axis of the measuring volume, and a superconducting capacitively acting conducting structure (3a-d) for generating the resonant capacity, also extending parallel to the longitudinal axis of the measuring volume, wherein the resonant circuit for generating the field B1 comprises those regions of the resonant circuit carrying the maximum current in the resonant circuit, and the capacitively acting conducting structure comprises those regions of the resonant circuit in which the current is reduced to zero,
- **that** the conducting structure for generating the field B1 is arranged separate from the capacitively acting conducting structure and is connected therewith via conductors extending obliquely to the longitudinal axis of the measurement volume,
- and **that** the conducting structure (2a-d) for generating the field B1 is arranged closer to the measuring volume than the capacitively acting conducting structure (3a-d).

2. HF resonator according to claim 1, **characterized in that** all superconducting resonant circuits on the planar substrate elements (1a, 1b, 1c, 1d, 19a, 19b, 20a, 20b, 20c, 20d) are tuned to the same resonance frequency.

3. HF resonator according to any one of the preceding claims, **characterized in that** at least part of the conducting structure (2a, 2b, 2c, 2d) for generating the field B1 touches the limiting cylinder (6).

4. HF resonator according to any one of the preceding claims, **characterized in that** the superconducting conducting paths of the conducting structure (3a, 3b, 3c, 3d), which is designed for generating the resonant capacity, by branching one conducting path each, are provided in the form of two or more conductor paths.

5. HF resonator according to claim 4, **characterized in that** in the conducting structure, which is designed for generating the resonant capacity of the resonant circuit, branched conducting paths engage each other like fingers, each finger being formed by one pair of conductor paths.

6. HF resonator according to claim 4, **characterized in that** in the conducting structure, which is designed for generating the resonant capacity of the resonant circuits, the said branched conductor paths engage each other individually and like fingers.

7. HF resonator according to claim 4, **characterized in that** in the conducting structure, which is designed for generating the resonant capacity of the resonant circuits, part of the branched conductor paths engage each other pairwise like fingers and the remaining part engage each other individually and like fingers.

8. HF resonator according to any one of the preceding claims, **characterized in that** the superconducting conducting structures are disposed on the side of the planar substrate elements (1a, 1b, 1c, 1d, 19a, 19b, 20a, 20b, 20c, 20d) facing the measuring volume.

9. HF resonator according to any one of the preceding claims, **characterized in that** two identical planar substrate elements (20b, 20d) are provided, the second substrate element (20d) being rotated with respect to the first substrate element (20b) by 180 degrees about the longitudinal axis of the measuring volume.

10. HF resonator according to any one of the preceding claims, **characterized in that** n identical planar substrate elements (20a, 20b, 20c, 20d) are provided which are rotated with respect to a first substrate element through 360/n, 2·360/n, 3·360/n, .... , (n-1) · 360/n degrees about the longitudinal axis of the measuring volume, thereby producing a symmetrical structure.

11. HF resonator according to claim 10 inasfar as claim 10 does not relate to claim 9 **characterized in that** n=4.

**12.** HF resonator according to any one of claims 1 through 8, **characterized in that** two parallel planar substrate elements (19a, 19b) disposed on opposing sides of the measuring volume are arranged so that they are symmetrical to each other with respect to a plane which includes the longitudinal axis of the measuring volume and is parallel to the substrate element plane, and that two superconducting resonant circuits each are provided on each of the two substrate elements (19a, 19b), said circuits being symmetrical to one another with respect to a plane which includes the longitudinal axis of the measuring volume and is perpendicular to the substrate element plane.

**13.** HF resonator according to any one of the claims 1 through 8, **characterized in that** two pairs of planar substrate elements (1a - d), each disposed in a V-shape to one another, are positioned with the open side facing the relevant V-shape of the measuring volume, wherein the pairs are disposed symmetrically to one another in relation to a plane including the longitudinal axis of the measuring volume, and that on the individual substrate elements (1a-d) one superconducting resonant circuit each is provided wherein at least part of the conducting structure designed for generating the field B1 touches the limiting cylinder (6).

**14.** HF resonator according to any one of the preceding claims, **characterized in that** the conductors extending obliquely to the longitudinal axis of the measuring volume have conductor paths which are broadened.

**15.** HF resonator arrangement having an HF resonator according to any one of the preceding claims, **characterized in that** additionally, at least one further superconducting or normal conducting HF resonator is provided.

**16.** HF resonator arrangement according to claim 15, **characterized in that** at least one of the further HF resonators also forms a HF resonator according to any one of claims 1 through 14.

**17.** HF resonator arrangement having an HF resonator according to claim 13, **characterized in that** an HF Helmholtz resonator is arranged about the pairs of planar substrate elements (1a, 1b, 1c, 1d) each being disposed to one another in a V-shape on the side of the substrate elements of the HF resonator facing away from the measuring volume, so that the HF Helmholtz resonator, when current-carrying, produces a field B1 in the center of the measuring volume which is perpendicular to the field B1 of the HF resonator according to claim 13, said field B1 being brought about by the superposition of the fields B1 of the individual resonant circuits, when said circuits are current-carrying simultaneously.

**Revendications**

**1.** Résonateur HF (haute fréquence) pour la réception de signaux de mesure RMN provenant d'un échantillon de mesure (5) dans un spectromètre RMN, lequel échantillon de mesure se trouve, pendant le fonctionnement, dans le volume de mesure du résonateur, lequel volume de mesure est plus étendu dans une dimension de l'espace que dans les deux autres et présente un axe longitudinal qui passe par le centre du volume de mesure, le résonateur comprenant plusieurs composants identiques entre eux qui présentent chacun un ou plusieurs circuits résonants composés de structures de conducteurs supraconductrices (2a-d, 3a-d) sur un élément de substrat planaire (1a-d, 19a,b, 20a-d), et les composants étant disposés autour du volume de mesure et les plans des éléments de substrat s'étendant tangentiellement à un cylindre de délimitation (6) imaginaire entourant l'axe longitudinal du volume de mesure, à l'intérieur duquel se trouve le volume de mesure,
**caractérisé en ce**

- **que** chaque circuit résonant appartenant au résonateur HF sur l'élément de substrat planaire génère, pris isolément, quand il est parcouru par un courant, au centre du volume de mesure un champ magnétique HF (= champ B1) qui s'étend parallèlement au plan de l'élément de substrat planaire sur lequel le circuit résonant se trouve, la divergence par rapport au parallélisme devant être de 40 degrés au maximum,
- **que** les circuits résonants sur les éléments de substrat planaires présentent chacun une structure de conducteurs supraconductrice (2a-d) s'étendant parallèlement à l'axe longitudinal du volume de mesure pour générer le champ B1 et une structure de conducteurs supraconductrice (3a-d) à action capacitive s'étendant également parallèlement à l'axe longitudinal du volume de mesure pour générer la capacité de résonance, la structure de conducteurs pour générer le champ B1 comprenant les zones du circuit résonant qui portent le courant maximal dans le circuit résonant et la structure de conducteurs à action capacitive comprenant les zones du circuit résonant dans lesquelles le courant est ramené à zéro,
- **que** la structure de conducteurs pour générer le champ B1 est disposée séparément de la structure de conducteurs à action capacitive et reliée à celle par l'intermédiaire de conducteurs s'étendant transversalement à l'axe longitudinal du volume de mesure,
- et **que** la structure de conducteurs (2a-d) pour générer le champ B1 est disposée plus près du volume de mesure que la structure de conducteurs (3a-d) à action capacitive.

2. Résonateur HF selon la revendication 1, **caractérisé en ce que** tous les circuits résonants supraconducteurs sur les éléments de substrat planaires (1a, 1b, 1c, 1d, 19a, 19b, 20a, 20b, 20c, 20d) sont accordés sur la même fréquence de résonance.

3. Résonateur HF selon une des revendications précédentes, **caractérisé en ce qu'**au moins une partie de la structure de conducteurs (2a, 2b, 2c, 2d) pour générer le champ B1 touche le cylindre de délimitation (6).

4. Résonateur HF selon une des revendications précédentes, **caractérisé en ce que** les pistes conductrices supraconductrices de la structure de conducteurs (3a, 3b, 3c, 3d) servant à générer la capacité de résonance sont formées chacune par ramification d'une piste conductrice en deux ou plusieurs pistes conductrices.

5. Résonateur HF selon la revendication 4, **caractérisé en ce que** dans la structure de conducteurs servant à générer la capacité de résonance des circuits de résonance, des pistes conductrices ramifiées sont imbriquées les unes dans les autres en forme de doigts, chaque doigt étant formé par une paire de pistes conductrices.

6. Résonateur HF selon la revendication 4, **caractérisé en ce que** dans la structure de conducteurs servant à générer la capacité de résonance des circuits de résonance, les pistes conductrices ramifiées sont imbriquées les unes dans les autres individuellement en forme de doigts.

7. Résonateur HF selon la revendication 4, **caractérisé en ce que** dans la structure de conducteurs servant à générer la capacité de résonance des circuits de résonance, une partie des pistes conductrices ramifiées sont imbriquées les unes dans les autres par paires en forme de doigts et la partie restante individuellement en forme de doigts.

8. Résonateur HF selon une des revendications précédentes, **caractérisé en ce que** les structures de conducteurs supraconductrices sont disposées sur le côté des éléments de substrat planaires (1a, 1b, 1c, 1d, 19a, 19b, 20a, 20b, 20c, 20d) tourné vers le volume de mesure.

9. Résonateur HF selon une des revendications précédentes, **caractérisé en ce que** deux éléments de substrat planaires identiques (20b, 20d) sont prévus, le deuxième élément de substrat (20d) étant tourné de 180 degrés autour de l'axe longitudinal du volume de mesure par rapport au premier élément de substrat (20b).

10. Résonateur HF selon une des revendications précédentes, **caractérisé en ce que** n éléments de substrat planaires identiques (20a, 20b, 20c, 20d) sont prévus, qui sont tournés de 360/n, 2·360/n, 3·360/n, ... (n-1)·360/n degrés autour de l'axe longitudinal du volume de mesure par rapport à un premier élément de substrat et forment ainsi une structure symétrique.

11. Résonateur HF selon la revendication 4, dans la mesure où la revendication 10 ne se réfère pas à la revendication 9, **caractérisé en ce que** n = 4.

12. Résonateur HF selon une des revendications 1 à 8, **caractérisé en ce que** deux éléments de substrat planaires (19a, 19b) parallèles entre eux et situés des deux côtés du volume de mesure sont disposés de manière à être symétriques l'un de l'autre par rapport à un plan qui contient l'axe longitudinal du volume de mesure et est parallèle au plan des éléments de substrat, et que sur chacun des deux éléments de substrat (19a, 19b) sont prévus deux circuits de résonance supraconducteurs qui sont symétriques l'un de l'autre par rapport à un plan qui contient l'axe longitudinal du volume de mesure et est perpendiculaire au plan des éléments de substrat.

13. Résonateur HF selon une des revendications 1 à 8, **caractérisé en ce que** deux paires d'éléments de substrat planaires (1a-d) disposés chaque fois en forme de V l'un par rapport à l'autre sont tournées avec le côté ouvert de la forme en V respective vers le volume de mesure, les paires étant positionnées symétriquement par rapport à un plan contenant l'axe longitudinal du volume de mesure, et que sur chacun des différents éléments de substrat planaires (1a-d) est prévu un circuit résonant supraconducteur dont au moins une partie de la structure de conducteurs servant à générer le champ B1 touche le cylindre de délimitation (6).

14. Résonateur HF selon une des revendications précédentes, **caractérisé en ce que** les conducteurs s'étendant transversalement à l'axe longitudinal du volume de mesure présentent des pistes conductrices élargies.

15. Dispositif à résonateur HF avec un résonateur HF selon une des revendications précédentes, **caractérisé en ce qu'**il est prévu en plus au moins un autre résonateur HF supraconducteur ou normalement conducteur.

16. Dispositif à résonateur HF selon la revendication 15, **caractérisé en ce qu'**au moins un des autres résonateurs HF forme également un résonateur HF selon une des revendications 1 à 14.

17. Dispositif à résonateur HF avec un résonateur HF selon la revendication 13, **caractérisé en ce qu'**autour des paires d'éléments de substrat planaires (1a, 1b, 1c, 1d) disposés chaque fois en forme de V l'un par rapport à l'autre, un résonateur HF de Helmholtz est disposé du côté des éléments de substrat du résonateur HF opposé au volume de mesure de telle manière que le résonateur HF de Helmholtz, lorsqu'il est parcouru par un courant, génère au centre du volume de mesure un champ B1 qui est perpendiculaire au champ B1 du résonateur HF selon la revendication 13, lequel résulte de la superposition des champs B1 des différents circuits résonants quand ceux-ci sont parcourus en même temps par un courant.

**Fig.1**

**B₁**

(3d) (1d) (2d) 1d

2d

3d

6

5

**Fig.2**

**Fig.3a**

**Fig.3b**

**Fig.4**

**Fig.5**

**Fig.6**

**Fig.7**

**Fig.8**

9b

10b

11b

**Fig.9**

1d

2d          3d

**Fig.10a**

1d

2d          3d

**Fig.10b**

**Fig.11**

**Fig.12**

**Fig.13**

**Fig.14**

**Fig.15**

**Fig.16**

**Fig.17**

**Fig.18**

**Fig.19**

**Fig.20**

Fig.21

Fig.22

**Fig.23**

**Fig.24**

Fig.25

Fig.26

Fig.27

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5585723 A
- DE 19733574 A1

- WO 9924844 A